(19) Europäisches Patentamt
European Patent Office
Office européen des brevets

(11) EP 3 081 598 B1

(12) EUROPEAN PATENT SPECIFICATION

(45) Date of publication and mention of the grant of the patent:
**10.06.2020 Bulletin 2020/24**

(21) Application number: **14870028.9**

(22) Date of filing: **09.12.2014**

(51) Int Cl.:
***C08L 77/00*** *(2006.01)* ***C08K 3/22*** *(2006.01)*
***C08K 3/32*** *(2006.01)*

(86) International application number:
**PCT/JP2014/082596**

(87) International publication number:
**WO 2015/087886 (18.06.2015 Gazette 2015/24)**

# (54) POLYAMIDE COMPOSITION, MOLDED ARTICLE, REFLECTIVE BOARD FOR LEDS, AND METHOD FOR PREVENTING HEAT-INDUCED REFLECTIVITY REDUCTION

POLYAMIDZUSAMMENSETZUNG, FORMARTIKEL, REFLEKTIERENDE PLATTE FÜR LEDS UND VERFAHREN ZUR VERHINDERUNG VON WÄRMEINDUZIERTER REFLEKTIVITÄTSREDUZIERUNG

COMPOSITION POLYAMIDE, ARTICLE MOULÉ, PLAQUE RÉFLÉCHISSANTE POUR DEL ET PROCÉDÉ POUR PRÉVENIR LA BAISSE DE RÉFLECTIVITÉ THERMO-INDUITE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2013 JP 2013258476**
**16.07.2014 JP 2014146237**

(43) Date of publication of application:
**19.10.2016 Bulletin 2016/42**

(73) Proprietor: **Asahi Kasei Kabushiki Kaisha**
**Chiyoda-ku**
**Tokyo**
**101-8101 (JP)**

(72) Inventors:
- **IEDA, Shinji**
**Tokyo 101-8101 (JP)**
- **FUJINO, Yoshinori**
**Tokyo 101-8101 (JP)**
- **NITTO, Yu**
**Tokyo 101-8101 (JP)**

(74) Representative: **D Young & Co LLP**
**120 Holborn**
**London EC1N 2DY (GB)**

(56) References cited:
**EP-A1- 2 944 674**
**WO-A1-2013/129201**
**JP-A- 2006 257 314**
**JP-A- 2011 021 128**
**JP-A- 2012 184 277**
**JP-A- 2013 227 556**
**US-A1- 2010 160 523**
**US-A1- 2013 172 453**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 081 598 B1

## Description

[Technical Field]

The present invention relates to a polyamide composition, a molded article, a reflective plate for LED, and a method for suppressing a reduction in reflectance due to heat.

[Background Art]

Polyamides typified by polyamide 6 (hereinafter, also referred to as "PA6") and polyamide 66 (hereinafter, also referred to as "PA66") are excellent in molding processability, mechanical property or chemical resistance, and therefore are widely used in various component materials for automobiles, electric and electronics, industrial materials, engineering materials, daily and household items, and the like.

As an environmental measure in the automobile industry, a reduction in the weight of a vehicle body is demanded for the purpose of a reduction in an exhaust gas. In order to respond to such a demand, polyamides are further increasingly used in an exterior material, an interior material and the like for automobiles, instead of metals. A polyamide for use in an exterior material and an interior material for automobiles is demanded to have characteristics such as heat resistance, strength and appearance at much higher levels. In particular, a polyamide for use in a material of an engine room is strongly demanded to have a higher heat resistance, in order to respond to a tendency of temperature rise in the engine room.

A lead-free solder is progressively used as a surface mount (SMT) solder in the electrical and electronic industries such as the home appliance industry. A polyamide for use in a material for home appliances is demanded to have a higher heat resistance so as to be capable of withstanding an increase in the melting point of the SMT solder based on the use of the lead-free solder.

Conventional polyamides such as PA6 and PA66, however, have melting points and cannot satisfy such a demand in terms of heat resistance.

In order to solve the problem about heat resistance of conventional polyamides such as PA6 and PA66, a high melting point polyamide is proposed. Specifically, for example, a polyamide made of terephthalic acid and hexamethylenediamine (hereinafter, also referred to as "PA6T") is proposed.

PA6T, however, is a high melting point polyamide having a melting point of about 370°C. Therefore, even when a molded article is tried to be obtained from PA6T by melt molding, the polyamide is pyrolyzed in the course of molding and has the problem of having difficulty in providing a molded article having sufficient characteristics.

In order to solve the problem of pyrolysis of PA6T, for example, a high melting point semi-aromatic polyamide mainly made of terephthalic acid and hexamethylenediamine (hereinafter, also referred to as "6T-based copolymer polyamide") is proposed in which PA6T is copolymerized with an aliphatic polyamide such as PA6 and PA66, an amorphous aromatic polyamide made of isophthalic acid and hexamethylenediamine (hereinafter, also referred to as "PA6I") or the like to thereby allow the melting point to be decreased to about 220 to 340°C.

For example, Patent Literature 1 discloses, as a 6T-based copolymer polyamide, an aromatic polyamide that is made of an aromatic dicarboxylic acid and an aliphatic diamine, in which the aliphatic diamine is a mixture of hexamethylenediamine and 2-methylpentamethylenediamine, (hereinafter, also referred to as "PA6T/2MPDT").

In addition, Patent Literature 2 discloses a semi-alicyclic polyamide in which 1 to 40% of 1,4-cyclohexanedicarboxylic acid is incorporated as a dicarboxylic acid unit, and discloses the following: an electric and electronic member including the semi-alicyclic polyamide has an enhanced solder heat resistance.

Furthermore, Patent Literature 3 discloses a polyamide composition including a polyamide resin made of a dicarboxylic acid containing a terephthalic acid unit and a diamine containing a 1,9-nonanediamine unit and/or a 2-methyl-1,8-octanediamine unit (hereinafter, also referred to as "PA9T"), titanium oxide, magnesium hydroxide and a specific reinforcing material, and discloses the following: the polyamide composition is excellent in heat resistance.

Moreover, Patent Literature 4 discloses a polyamide composition that contains a semi-alicyclic polyamide with 70% or more of 1,4-cyclohexanedicarboxylic acid incorporated as a dicarboxylic acid unit, titanium oxide and an inorganic filler, the mass ratio of which is a predetermined value, and discloses the following: the polyamide composition is excellent in reflow resistance, heat resistance and the like.

[Citation List]

[Patent Literature]

[Patent Literature 1]
National Publication of International Patent Application No. 6-503590
[Patent Literature 2]
National Publication of International Patent Application No. 11-512476
[Patent Literature 3]
Japanese Patent Laid-Open No. 2006-257314
[Patent Literature 4]
Japanese Patent Laid-Open No. 2011-219697

[Summary of Invention]

[Technical Problem]

The conventional polyamides or polyamide compositions described in Patent Literatures 1 to 4 and the like, however, have not yet achieved sufficient characteristics in terms of heat discoloration resistance, extrusion processability and molding stability, and such characteristics have been demanded to be further improved.
In view of the prior art problem described above, an object of the present invention is to provide a polyamide composition excellent in not only heat discoloration resistance, extrusion processability and molding stability, but also whiteness and reflow resistance.

[Solution to Problem]

The present inventors have made intensive studies in order to solve the above problem, and as a result, have found that a polyamide composition containing a polyamide, a metal hydroxide and/or a metal oxide, and a phosphorus-based compound can solve the above problem, leading to the completion of the present invention.
That is, the present invention is as follows.
[1] A polyamide composition comprising:

a polyamide (A),
0.1 to 20% by mass of a metal hydroxide (C), wherein the metal hydroxide is calcium hydroxide and/or a metal oxide (D), wherein the metal oxide is calcium oxide (D),
0.1 to 20% by mass of a phosphorus-based compound (E), and

further comprising 5% by mass or more of an inorganic filler (F)) selected from the group consisting of glass fiber, carbon fiber, calcium silicate fiber, potassium titanate fiber, aluminum borate fiber, glass flake, talc, kaolin, mica, hydrotalcite, calcium carbonate, zinc carbonate, zinc oxide, wollastonite, silica, zeolite, alumina, boehmite, aluminum hydroxide, silicon oxide, calcium silicate, sodium aluminosilicate, magnesium silicate, carbon nanotube, graphite, brass, copper, silver, aluminum, nickel, iron, calcium fluoride, montmorillonite, and swellable fluorine mica.
[2] The polyamide composition according to the above [1], wherein the polyamide (A) has a melting point of 270 to 350°C.
[3] The polyamide composition according to the above [1] or [2], wherein the polyamide (A) is a polyamide comprising a dicarboxylic acid comprising 50% by mol or more of an alicyclic dicarboxylic acid as a monomer for polymerization.
[4] The polyamide composition according to the above [3], wherein the alicyclic dicarboxylic acid comprises 1,4-cyclohexanedicarboxylic acid.
[5] The polyamide composition according to any one of the above [1] to [4], further comprising 5% by mass or more of a titanium oxide (B).
[6] The polyamide composition according to any one of the above [1] to [5], wherein the phosphorus-based compound (E) is a metal salt, and a metal element of the metal salt is the same as a metal element of the metal hydroxide (C) and/or the metal oxide (D).
[7] The polyamide composition according to any one of the above [1] to [5], wherein the phosphorus-based compound (E) is an alkaline earth metal salt.
[8] The polyamide composition according to any one of the above [1] to [7], further comprising 0.001 to 15% by mass of a nucleating agent selected from the group consisting of boron nitride, barium sulfate, silicon nitride, carbon black, and molybdenum disulfide.
[9] The polyamide composition according to any one of the above [1] to [8], wherein a phosphorus element concentration derived from the phosphorus-based compound (E) comprised in the polyamide composition is 1,400 to 20,000

ppm, and a difference (Tc - Tg) between a crystallization peak temperature Tc obtained in cooling at 100°C/min in differential scanning calorimetry according to JIS-K7121, and a glass transition temperature Tg is 100°C or higher.
[10] A molded article comprising the polyamide composition according to any one of the above [1] to [9].
[11] The molded article according to the above [10], wherein a reflectance retention rate after exposure for 1000 hours by a metal halide lamp system light resistance tester at 100°C and at a position where an illuminance is 10 $mW/cm^2$ is 95% or more.
[12] A reflective plate for LED, comprising the polyamide composition according to any one of the above [1] to [9].

[Advantageous Effect of Invention]

The present invention can provide a polyamide composition excellent in whiteness, reflow resistance, heat discoloration resistance, extrusion processability and molding stability.

[Description of Embodiments]

Hereinafter, an embodiment for carrying out the present invention (hereinafter, referred to as "present embodiment") is described in detail. Herein, the following present embodiment is illustrative for explaining the present invention, and is not intended to limit the present invention to the following content. The present invention can be variously modified and carried out within the scope thereof.

[Polyamide composition]

A polyamide composition of the present embodiment (hereinafter, simply referred to as "polyamide composition") contains:

a polyamide (A),
0.1 to 20% by mass of a metal hydroxide (C) and/or a metal oxide (D), and
0.1 to 20% by mass of a phosphorus-based compound (E) .

(Polyamide (A))

The polyamide (A) for use in the present embodiment has a dicarboxylic acid unit (a) and a diamine unit (b).
The total amount of the dicarboxylic acid unit (a) and the diamine unit (b) is preferably 20 to 100% by mol, more preferably 90 to 100% by mol, further preferably 100% by mol based on 100% by mol of all the constituent units of the polyamide (A).
In the present embodiment, the proportion of a predetermined monomer unit forming the polyamide (A) can be measured by nuclear magnetic resonance spectrometry (NMR) and the like.
In the polyamide (A), examples of a constituent unit of the polyamide (A), other than the dicarboxylic acid unit (a) and the diamine unit (b), include, but not particularly limited, a unit (c) including lactam and/or aminocarboxylic acid, described later.
In the present embodiment, the "polyamide" means a polymer having an amide (-NHCO-) bond in a main chain.

<Dicarboxylic acid unit (a)>

Examples of the dicarboxylic acid unit (a) include, but not limited to the following, an alicyclic dicarboxylic acid unit (a-1), an aromatic dicarboxylic acid unit (a-2) and an aliphatic dicarboxylic acid unit (a-3).
The dicarboxylic acid unit (a) preferably includes 50 to 100% by mol of the alicyclic dicarboxylic acid unit (a-1) (based on the total molar number of the dicarboxylic acid), more preferably 60 to 100% by mol, further preferably 70 to 100% by mol, still more preferably 100% by mol.
When the proportion (% by mol) of the alicyclic dicarboxylic acid unit (a-1) in the dicarboxylic acid unit (a) is within the above range, a polyamide composition that simultaneously satisfies heat resistance, fluidity, toughness, low water-absorption property and rigidity can be obtained.

[Alicyclic dicarboxylic acid unit (a-1)]

Examples of the alicyclic dicarboxylic acid forming the alicyclic dicarboxylic acid unit (a-1) (hereinafter, also referred to as "alicyclic dicarboxylic acid unit") include, but not limited to the following, alicyclic dicarboxylic acids in which the number of carbon atoms in the alicyclic structure is 3 to 10, and an alicyclic dicarboxylic acid in which the number

of carbon atoms in the alicyclic structure is 5 to 10 is preferable.

Examples of such an alicyclic dicarboxylic acid include, but not limited to the following, 1,4-cyclohexanedicarboxylic acid, 1,3-cyclohexanedicarboxylic acid and 1,3-cyclopentanedicarboxylic acid. Among them, 1,4-cyclohexanedicarboxylic acid is preferable.

The polyamide composition includes such an alicyclic dicarboxylic acid, and thus tends to be more excellent in heat resistance, low water-absorption property and rigidity.

Herein, the alicyclic dicarboxylic acid forming the alicyclic dicarboxylic acid unit (a-1) may be used singly or in combinations of two or more.

The alicyclic group in the alicyclic dicarboxylic acid may be unsubstituted or may have a substituent.

Examples of the substituent include, but not limited to the following, alkyl groups having 1 to 4 carbon atoms, such as a methyl group, an ethyl group, a n-propyl group, an isopropyl group, a n-butyl group, an isobutyl group and a tert-butyl group.

The alicyclic dicarboxylic acid forming the alicyclic dicarboxylic acid unit (a-1) has geometric isomers (trans isomer and cis isomer).

The alicyclic dicarboxylic acid as a raw material monomer may be used as any one of a trans isomer and a cis isomer or a mixture including a trans isomer and a cis isomer at a predetermined ratio.

Herein, the alicyclic dicarboxylic acid is known to be isomerized at a high temperature to form a trans isomer and a cis isomer at a certain ratio, an alicyclic dicarboxylic acid as a cis isomer tends to be higher in water solubility of an equivalent salt of the alicyclic dicarboxylic acid and the diamine than an alicyclic dicarboxylic acid as a trans isomer. Thus, the trans isomer/cis isomer ratio (molar ratio) of the alicyclic dicarboxylic acid as a raw material monomer is preferably 50/50 to 0/100, more preferably 40/60 to 10/90, further preferably 35/65 to 15/85.

The trans isomer/cis isomer ratio (molar ratio) of the alicyclic dicarboxylic acid can be determined by liquid chromatography (HPLC) and nuclear magnetic resonance spectrometry (NMR).

The alicyclic dicarboxylic acid unit (a-1) in the polyamide (A) has geometric isomers (trans isomer and cis isomer).

The ratio of the trans isomer to all the alicyclic dicarboxylic acid units (a-1) in the polyamide (A) refers to the "trans isomer ratio". The trans isomer ratio is preferably 50 to 85% by mol, more preferably 50 to 80% by mol, further preferably 60 to 80% by mol.

When the trans isomer ratio is within the above range, the polyamide composition of the present embodiment tends to simultaneously satisfy not only characteristics such as a high melting point, and more excellent toughness and rigidity, but also rigidity on heating due to a high glass transition temperature (Tg), fluidity that is usually a characteristic inconsistent with heat resistance, and a high crystallinity.

Such characteristics are particularly remarkably exhibited in a polyamide (A) that is obtained by a combination of a dicarboxylic acid unit (a) including 50% by mol or more of 1,4-cyclohexanedicarboxylic acid and a diamine unit (b) including 50% by mol or more of 2-methylpentamethylenediamine, in which the trans isomer ratio is 50 to 85% by mol.

The "trans isomer ratio" can be measured by a method described in Examples later.

[Aromatic dicarboxylic acid unit (a-2)]

Examples of the aromatic dicarboxylic acid forming the aromatic dicarboxylic acid unit (a-2) include, but not limited to the following, dicarboxylic acids having a phenyl group or a naphthyl group. The aromatic group in the aromatic dicarboxylic acid may be unsubstituted or may have a substituent.

Examples of the substituent include, but not particularly limited, alkyl groups having 1 to 4 carbon atoms, aryl groups having 6 to 10 carbon atoms, arylalkyl groups having 7 to 10 carbon atoms, halogen groups such as a chloro group and a bromo group, silyl groups having 1 to 6 carbon atoms, and sulfonic acid and salts thereof (sodium salt and the like).

The aromatic dicarboxylic acid includes, but not limited to the following, aromatic dicarboxylic acids having 8 to 20 carbon atoms, which are unsubstituted or have a predetermined substituent, such as terephthalic acid, isophthalic acid, naphthalenedicarboxylic acid, 2-chloroterephthalic acid, 2-methylterephthalic acid, 5-methylisophthalic acid and 5-sodiumsulfoisophthalic acid.

The aromatic dicarboxylic acid forming the aromatic dicarboxylic acid unit (a-2) may be used singly or in combinations of two or more.

[Aliphatic dicarboxylic acid unit (a-3)]

Examples of the aliphatic dicarboxylic acid forming the aliphatic dicarboxylic acid unit (a-3) include, but not limited to the following, linear or branched saturated aliphatic dicarboxylic acids having 3 to 20 carbon atoms, such as malonic acid, dimethylmalonic acid, succinic acid, 2,2-dimethylsuccinic acid, 2,3-dimethylglutaric acid, 2,2-diethylsuccinic acid, 2,3-diethylglutaric acid, glutaric acid, 2,2-dimethylglutaric acid, adipic acid, 2-methyladipic acid, trimethyladipic

acid, pimelic acid, suberic acid, azelaic acid, sebacic acid, dodecanedioic acid, tetradecanedioic acid, hexadecanedioic acid, octadecanedioic acid, eicosandioic acid and diglycollic acid.

A dicarboxylic acid unit other than the alicyclic dicarboxylic acid unit (a-1) preferably includes the aliphatic dicarboxylic acid unit (a-3), more preferably includes an aliphatic dicarboxylic acid having 6 or more carbon atoms.

When such a dicarboxylic acid is used, the polyamide composition tends to be more excellent in heat resistance, fluidity, toughness, low water-absorption property and rigidity.

in particular, the aliphatic dicarboxylic acid (a-3) is preferably an aliphatic dicarboxylic acid having 10 or more carbon atoms. When such a dicarboxylic acid is used, the polyamide composition tends to be more excellent in heat resistance, low water-absorption property and the like.

Examples of the aliphatic dicarboxylic acid having 10 or more carbon atoms include, but not particularly limited, sebacic acid, dodecanedioic acid, tetradecanedioic acid, hexadecanedioic acid, octadecanedioic acid and eicosandioic acid. In particular, sebacic acid and dodecanedioic acid are preferable in terms of heat resistance and the like of the polyamide composition.

The aliphatic dicarboxylic acid forming the aliphatic dicarboxylic acid unit (a-3) may be used singly or in combinations of two or more.

The proportion (% by mol) of the dicarboxylic acid other than the alicyclic dicarboxylic acid unit (a-1) in the dicarboxylic acid unit (a) is preferably 0 to 50% by mol, more preferably 0 to 40% by mol, further preferably 0 to 30% by mol.

When the aliphatic dicarboxylic acid (a-3) having 10 or more carbon atoms is included, the proportion of the alicyclic dicarboxylic acid (a-1) and that of the aliphatic dicarboxylic acid (a-3) are preferably 50 to 99.9% by mol and 0.1 to 50% by mol, respectively, the proportion of the alicyclic dicarboxylic acid (a-1) and that of the aliphatic dicarboxylic acid (a-3) are more preferably 60 to 95% by mol and 5 to 40% by mol, respectively, and the proportion of the alicyclic dicarboxylic acid (a-1) and that of the aliphatic dicarboxylic acid (a-3) are further preferably 80 to 95% by mol and 5 to 20% by mol, respectively.

When the proportion of the aliphatic dicarboxylic acid unit (a-3) having 10 or more carbon atoms is within the above range, a polyamide composition that simultaneously satisfies more excellent heat resistance, fluidity, toughness, low water-absorption property, rigidity and the like tends to be obtained.

In the present embodiment, the dicarboxylic acid forming the dicarboxylic acid unit (a) is not limited to the above compounds recited as the dicarboxylic acid, and may be any compound equivalent to the dicarboxylic acid.

The "compound equivalent to the dicarboxylic acid" here refers to a compound that can have the same dicarboxylic acid structure as the dicarboxylic acid structure derived from the dicarboxylic acid. Examples of such a compound include, but not limited to the following, anhydrides and halides of the dicarboxylic acid.

The polyamide (A) may also further include a unit derived from a tri- or higher valent carboxylic acid such as trimellitic acid, trimesic acid and pyromellitic acid, if necessary.

The tri- or higher valent carboxylic acid may be used singly or in combinations of two or more.

<Diamine unit (b)>

Examples of the diamine unit (b) include, but not limited to the following, a diamine unit (b-1) having a substituent branched from the main chain, an aliphatic diamine unit (b-2), an alicyclic diamine unit (b-3) and an aromatic diamine unit (b-4).

The diamine unit (b) preferably includes the diamine (b-1) having a substituent branched from the main chain.

When the diamine unit (b) includes the diamine unit (b-1) having a substituent branched from the main chain, the polyamide composition of the present embodiment tends to be able to simultaneously satisfy more excellent fluidity, toughness, rigidity and the like.

The diamine unit (b) more preferably includes 50% by mol or more of the diamine unit (b-1) having a substituent branched from the main chain.

[Diamine unit (b-1) having substituent branched from the main chain]

In the diamine unit (b-1) having a substituent branched from the main chain, examples of such a "substituent branched from the main chain" include, but not limited to the following, alkyl groups having 1 to 4 carbon atoms, such as a methyl group, an ethyl group, a n-propyl group, an isopropyl group, a n-butyl group, an isobutyl group and a tert-butyl group.

Examples of the diamine forming the diamine unit (b-1) having a substituent branched from the main chain include, but not limited to the following, branched saturated aliphatic diamines having 3 to 20 carbon atoms, such as 2-methylpentamethylenediamine (hereinafter, also referred to as "2-methyl-1,5-diaminopentane"), 2,2,4-trimethylhexamethylenediamine, 2,4,4-trimethylhexamethylenediamine, 2-methyloctamethylenediamine and 2,4-dimethyloctamethylenediamine.

Among them, 2-methylpentamethylenediamine is preferable. The diamine unit (b-1) having a substituent branched from the main chain is included, and thus a polyamide composition more excellent in heat resistance, rigidity and the like tends to be obtained.
Herein, the diamine forming the diamine unit (b-1) having a substituent branched from the main chain may be used singly or in combinations of two or more.
The proportion (% by mol) of the diamine unit (b-1) having a substituent branched from the main chain in the diamine unit (b) is preferably 50 to 100% by mol, more preferably 60 to 100% by mol, further preferably 85 to 100% by mol, still more preferably 90 to 100% by mol, further preferably 100% by mol.
When the proportion of the diamine unit (b-1) having a substituent branched from the main chain in the diamine unit (b) is within the above range, a polyamide composition more excellent in fluidity, toughness and rigidity tends to be obtained.

[Aliphatic diamine unit (b-2)]

Examples of the aliphatic diamine (excluding the diamine (b-1) having a substituent branched from the main chain) forming the aliphatic diamine unit (b-2) include, but not limited to the following, linear saturated aliphatic diamines having 2 to 20 carbon atoms, such as ethylenediamine, propylenediamine, tetramethylenediamine, pentamethylenediamine, hexamethylenediamine, heptamethylenediamine, octamethylenediamine, nonamethylenediamine, decamethylenediamine, undecamethylenediamine, dodecamethylenediamine and tridecamethylenediamine.

[Alicyclic diamine unit (b-3)]

Examples of the alicyclic diamine (hereinafter, also referred to as "alicyclic diamine") forming the alicyclic diamine unit (b-3) include, but not limited to the following, 1,4-cyclohexanediamine, 1,3-cyclohexanediamine and 1,3-cyclopentanediamine.

[Aromatic diamine unit (b-4)]

Examples of the aromatic diamine forming the aromatic diamine unit (b-4) include, but not limited to the following, metaxylilenediamine as long as the aromatic diamine is a diamine containing an aromatic moiety.
Among the above diamine units (b-2) to (b-4), the aliphatic diamine unit (excluding the diamine unit (b-1)) and the alicyclic diamine unit (b-3) are preferable, a diamine unit (b-2) having a linear saturated aliphatic group having 4 to 13 carbon atoms is more preferable, a diamine unit (b-2) having a linear saturated aliphatic group having 6 to 10 carbon atoms is further preferable, and hexamethylenediamine is still more preferable.
When such a diamine is used, a polyamide composition more excellent in heat resistance, fluidity, toughness, low water-absorption property, rigidity and the like tends to be obtained.
Herein, the diamine may be used singly or in combinations of two or more.
The total proportion (% by mol) of the diamine units (b-2) to (b-4) is preferably 0 to 50% by mol, more preferably 0 to 40% by mol, further preferably 0 to 30% by mol based on all the diamine units (b).
When the total proportion (% by mol) of the diamine units (b-2) to (b-4) in the diamine unit (b) is within the above range, a polyamide composition more excellent in fluidity, toughness and rigidity tends to be obtained.
Herein, the polyamide (A) may also further include a tri- or higher valent aliphatic amine such as bishexamethylenetriamine, if necessary.
The tri- or higher valent aliphatic amine may be used singly or may be used in combination of two or more.

<(c) Lactam unit (c-1) and/or aminocarboxylic acid unit (c-2)>

The polyamide (A) can further contain (c) a lactam unit (c-1) and/or an aminocarboxylic acid unit (c-2).
When such a unit is included, a polyamide composition more excellent in toughness tends to be obtained. The lactam and the aminocarboxylic acid forming the lactam unit (c-1) and the aminocarboxylic acid unit (c-2) here refer to polymerizable (polycondensatable) lactam and aminocarboxylic acid, respectively.
Examples of the lactam and the aminocarboxylic acid forming the lactam unit (c-1) and the aminocarboxylic acid unit (c-2) preferably include, but not limited to the following, lactams and aminocarboxylic acids having 4 to 14 carbon atoms, more preferably lactams and aminocarboxylic acids having 6 to 12 carbon atoms, respectively.
Examples of the lactam forming the lactam unit (c-1) include, but not limited to the following, butyrolactam, pivalolactam, ε-caprolactam, caprylolactam, enantholactam, undecanolactam and laurolactam (dodecanolactam).
Among them, the lactam is preferably ε-caprolactam, laurolactam or the like, more preferably ε-caprolactam. When such a lactam is included, a polyamide composition more excellent in toughness tends to be obtained.

Examples of the aminocarboxylic acid forming the aminocarboxylic acid unit (c-2) include, but not limited to the following, ω-aminocarboxylic acid and α,ω-amino acid that are compounds obtained by ring-opening of the lactam.
The aminocarboxylic acid is preferably a linear or branched saturated aliphatic carboxylic acid having 4 to 14 carbon atoms, which is substituted with an amino group at the ω-position. Examples of such an aminocarboxylic acid include, but not limited to the following, 6-aminocaproic acid, 11-aminoundecanoic acid and 12-aminododecanoic acid. The aminocarboxylic acid also includes p-aminomethylbenzoic acid.
The lactam and the aminocarboxylic acid forming the lactam unit (c-1) and the aminocarboxylic acid unit (c-2), respectively, may be used singly or in combinations of two or more.
The total proportion (% by mol) of the lactam unit (c-1) and the aminocarboxylic acid unit (c-2) is preferably 0 to 20% by mol, more preferably 0 to 10% by mol, further preferably 0 to 5% based on the entire polyamide (A).
When the total proportion of the lactam unit (c-1) and the aminocarboxylic acid unit (c-2) is within the above range, the effect of enhancing fluidity and the like tends to be achieved.

<Terminal blocking agent>

The terminal of the polyamide (A) for use in the present embodiment may be blocked by a known terminal blocking agent.
Such a terminal blocking agent can also be added as a molecular weight modifier in production of the polyamide (A) from the dicarboxylic acid and the diamine, and the lactam and/or the aminocarboxylic acid that is, if necessary, used.
Examples of the terminal blocking agent include, but not limited to the following, monocarboxylic acids, monoamines, anhydrides such as phthalic anhydride, monoisocyanates, monoacid halides, monoesters and monoalcohols.
Among them, monocarboxylic acids and monoamines are preferable. When the terminal of the polyamide (A) is blocked by the terminal blocking agent, a polyamide composition more excellent in heat stability tends to be obtained.
The terminal blocking agent may be used singly or in combinations of two or more.
A monocarboxylic acid that can be used as the terminal blocking agent can be any as long as such a monocarboxylic acid has a reactivity with an amino group that can be present at the terminal of the polyamide (A) and examples thereof include, but not limited to the following, aliphatic monocarboxylic acids such as formic acid, acetic acid, propionic acid, butyric acid, valeric acid, caproic acid, caprylic acid, lauric acid, tridecylic acid, myristic acid, palmitic acid, stearic acid, pivalic acid and isobutyric acid; alicyclic monocarboxylic acids such as cyclohexanecarboxylic acid; and aromatic monocarboxylic acids such as benzoic acid, toluic acid, α-naphthalenecarboxylic acid, β-naphthalenecarboxylic acid, methylnaphthalenecarboxylic acid and phenylacetic acid.
The monocarboxylic acid may be used singly or in combinations of two or more.
A monoamine that can be used as the terminal blocking agent can be any as long as such a monoamine has a reactivity with a carboxyl group that can be present at the terminal of the polyamide (A) and examples thereof include, but not limited to the following, aliphatic monoamines such as methylamine, ethylamine, propylamine, butylamine, hexylamine, octylamine, decylamine, stearylamine, dimethylamine, diethylamine, dipropylamine and dibutylamine; alicyclic monoamines such as cyclohexylamine and dicyclohexylamine; and aromatic monoamines such as aniline, toluidine, diphenylamine and naphthylamine.
The monoamine may be used singly or in combinations of two or more.
A polyamide composition containing a polyamide (A), the terminal of which is blocked by the terminal blocking agent, tends to be excellent in heat resistance, fluidity, toughness, low water-absorption property and rigidity.

(Method for producing polyamide (A))

The method for producing the polyamide (A) includes, but not limited to the following, for example, a method including a step of subjecting the dicarboxylic acid forming the dicarboxylic acid unit (a), the diamine forming the diamine unit (b), and if necessary, the lactam and/or the aminocarboxylic acid forming the lactam unit (c-1) and/or the aminocarboxylic acid unit (c-2), respectively, to polymerization to provide a polymer, preferably further including a step of increasing the degree of polymerization of the polyamide. The method may also include, if necessary, a blocking step of blocking the terminal of the resulting polymer by the terminal blocking agent.

Examples of a specific method for producing the polyamide (A) include various methods exemplified below.

1) A method in which a dicarboxylic acid-diamine salt, or a solution of a mixture of a dicarboxylic acid and a diamine in water or a suspension of the mixture in water is heated, and subjected to polymerization with the melting state being maintained (hereinafter, also referred to as "hot melt polymerization method").

2) A method in which a polyamide obtained by the hot melt polymerization method is subjected to an increase in the degree of polymerization with the solid state being maintained at a temperature equal to or lower than the melting point of the polyamide (hereinafter, also referred to as "hot melt polymerization-solid phase polymerization method").
3) A method in which a dicarboxylic acid-diamine salt, or a solution of a mixture of a dicarboxylic acid and a diamine in water or a suspension of the mixture in water is heated, and a prepolymer precipitated is again molten by an extruder such as a kneader for an increase in the degree of polymerization (hereinafter, also referred to as "prepolymer-extrusion polymerization method").
4) A method in which a dicarboxylic acid-diamine salt, or a solution of a mixture of a dicarboxylic acid and a diamine in water or a suspension of the mixture in water is heated, and a prepolymer precipitated is subjected to a further increase in the degree of polymerization with the solid state being maintained at a temperature equal to or lower than the melting point of the polyamide (hereinafter, also referred to as "prepolymer-solid phase polymerization method").
5) A method in which a dicarboxylic acid-diamine salt or a mixture of a dicarboxylic acid and a diamine is subjected to polymerization with the solid state being maintained (hereinafter, also referred to as "solid phase polymerization method").
6) A method in which a dicarboxylic acid halide component equivalent to the dicarboxylic acid, and a diamine component are used for polymerization (hereinafter, also referred to as "solution method").

When the polyamide (A) is produced, the amount of the dicarboxylic acid forming the dicarboxylic acid unit (a) to be added and the amount of the diamine forming the diamine unit (b) to be added are preferably around the same molar amount.
In consideration of a fraction of the diamine forming the diamine unit (b), to be escaped out of the reaction system in the polymerization reaction, with respect to the molar ratio, the molar amount of the entire diamine forming the diamine unit (b) per mol of the entire dicarboxylic acid forming the dicarboxylic acid unit (a) is preferably 0.9 to 1.2, more preferably 0.95 to 1.1, further preferably 0.98 to 1.05.
In production of the polyamide (A), polymerization is preferably conducted with the trans isomer ratio of the alicyclic dicarboxylic acid unit in the polyamide being maintained at 85% or less, and in particular, polymerization is more preferably conducted with the trans isomer ratio of the alicyclic dicarboxylic acid unit being maintained at 80% or less, in terms of fluidity of the polyamide.
In particular, when polymerization is conducted with the trans isomer ratio of the alicyclic dicarboxylic acid unit in the polyamide being maintained at 80% or less, a polyamide further excellent in color tone and tensile elongation and high in melting point tends to be obtained.
In the method for producing the polyamide (A), it is preferable that the polymerization temperature be increased and/or the polymerization time be increased in order to increase the degree of polymerization of the polyamide for an increase in the melting point. When the polymerization temperature is increased and/or the polymerization time is increased, polymerization is preferably conducted with the trans isomer ratio of the alicyclic dicarboxylic acid unit being maintained at 80% or less. Thus, coloration of the polyamide (A) due to heating and a reduction in tensile elongation due to thermal degradation tend to be able to be suppressed. In addition, a remarkable reduction in the rate of increase of the molecular weight of the polyamide (A) tends to be able to be suppressed.
The method for producing the polyamide (A) is preferably 1) the hot melt polymerization method and 2) the hot melt polymerization-solid phase polymerization method from the viewpoints that the trans isomer ratio of the alicyclic dicarboxylic acid unit in the polyamide is easily maintained at 85% or less and the resulting polyamide is excellent in color tone.
In the method for producing the polyamide (A), the polymerization form is not particularly limited, and may be of batch type or continuous type.
The polymerization apparatus for use in production of the polyamide (A) is not particularly limited, a known apparatus can be used therefor, and examples thereof include an autoclave type reactor, a tumbler type reactor, and an extruder type reactor such as a kneader.
Hereinafter, the method for producing the polyamide by a batch type hot melt polymerization method is specifically shown as the method for producing the polyamide (A), but the method for producing the polyamide (A) is not limited thereto.
First, for example, an aqueous solution containing about 40 to 60% by mass of raw material components (dicarboxylic acid, diamine, and if necessary, lactam and/or aminocarboxylic acid) of the polyamide is concentrated to a concentration of about 65 to 90% by mass in a concentration tank operated at a temperature of 110 to 180°C and a pressure of about 0.035 to 0.6 MPa (gauge pressure), providing a concentrated solution.
Next, the resulting concentrated solution is transferred to an autoclave, and heating is continued until the pressure in the autoclave reaches about 1.5 to 5.0 MPa (gauge pressure).
Thereafter, in the autoclave, the pressure is kept at about 1.5 to 5.0 MPa (gauge pressure) while water and/or

a gas component being drained, and the pressure is decreased to the atmospheric pressure (gauge pressure: 0 MPa) when the temperature reaches about 250 to 350°C.

After the pressure in the autoclave is decreased to the atmospheric pressure, the pressure can be if necessary reduced to thereby effectively remove water as a by-product.

Thereafter, the autoclave is pressurized with an inert gas such as nitrogen, and a molten polyamide product is extruded as a strand from the autoclave. The strand extruded is cooled and cut to thereby provide a pellet of the polyamide (A).

In addition, hereinafter, the method for producing the polyamide by a continuous type hot melt polymerization method is specifically shown.

First, an aqueous solution containing about 40 to 60% by mass of raw material components (dicarboxylic acid, diamine, and if necessary, lactam and/or aminocarboxylic acid) of the polyamide is preliminarily heated to about 40 to 100°C in the vessel of a preliminary apparatus. Next, the aqueous solution preliminarily heated is transferred to a concentration tank/reactor, and concentrated to a concentration of about 70 to 90% at a pressure of about 0.1 to 0.5 MPa (gauge pressure) and a temperature of about 200 to 270°C to provide a concentrated solution.

The resulting concentrated solution is discharged to a flasher kept at a temperature of about 200 to 350°C.

Thereafter, the pressure in the flasher is decreased to the atmospheric pressure (gauge pressure: 0 MPa). After the pressure in the flasher is decreased to the atmospheric pressure, the pressure is further reduced, if necessary. Thereafter, a molten polyamide product is extruded as a strand from the flasher. The strand extruded is cooled and cut to thereby provide a pellet of the polyamide (A).

<Polymer terminal of polyamide (A)>

The polymer terminal of the polyamide (A) for use in the present embodiment is, but not particularly limited, classified and defined as follows:

1) an amino terminal, 2) a carboxylic acid terminal, 3) a cyclic amino terminal, 4) a terminal by a blocking agent, and 5) other terminal.

The amino terminal 1) is a polymer terminal having an amino group (-$NH_2$ group), and derived from the diamine unit (b) as a raw material.

The amount of the amino terminal is preferably 5 to 100 μeq/g, more preferably 5 to 70 μeq/g, further preferably 5 to 50 μeq/g, still more preferably 5 to 30 μeq/g, more further preferably 5 to 20 μeq/g per gram of the polyamide (A).

When the amount of the amino terminal is within the above range, the polyamide composition tends to be more excellent in whiteness, reflow resistance, heat discoloration resistance, light discoloration resistance, hydrolysis resistance and heat retention stability. The amount of the amino terminal can be measured by neutralization titration.

The carboxylic acid terminal 2) is a polymer terminal having a carboxyl group (-COOH group) and is derived from the dicarboxylic acid (a) as a raw material.

The amount of the carboxylic acid terminal is preferably 5 to 100 μeq/g, more preferably 5 to 70 μeq/g, further preferably 5 to 50 μeq/g, still more preferably 5 to 30 μeq/g, more further preferably 5 to 20 μeq/g per gram of the polyamide (A). When the amount of the carboxylic acid terminal is within the above range, the polyamide composition tends to be more excellent in whiteness, reflow resistance, heat discoloration resistance and light discoloration resistance. The amount of the carboxylic acid terminal can be measured by neutralization titration.

The total amount of the amount of the amino terminal and the amount of the carboxylic acid terminal is preferably 10 to 200 μeq/g, more preferably 10 to 150 μeq/g, further preferably 10 to 100 μeq/g, still more preferably 15 to 50 μeq/g, more further preferably 20 to 40 μeq/g per gram of the polyamide (A). When the total amount of the amount of the amino terminal and the amount of the carboxylic acid terminal is within the above range, the polyamide composition tends to be more excellent in whiteness, reflow resistance, heat discoloration resistance and light discoloration resistance.

The cyclic amino terminal 3) is a polymer terminal having a cyclic amino group (group represented by the following (Formula 1)).

In the following (Formula 1), R represents a substituent that is bound to carbon forming a piperidine ring. Specific examples of R include a hydrogen atom, a methyl group, an ethyl group and a t-butyl group.

Alternatively, such a cyclic amino group is formed even when a piperidine cyclized by the deammoniation reaction of a diamine having a pentamethylenediamine backbone as a raw material is bound to the polymer terminal, for example. Such a structure may be formed when a monomer having a pentamethylenediamine backbone is included.

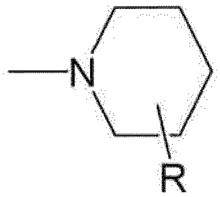

· · · (Formula 1)

The amount of the cyclic amino terminal 3) is preferably 30 μeq/g or more and 65 μeq/g or less, more preferably 30 μeq/g or more and 60 μeq/g or less, further preferably 35 μeq/g or more and 55 μeq/g or less per gram of the polyamide (A).

When the amount of the cyclic amino terminal is within the above range, the polyamide composition of the present embodiment tends to be more excellent in toughness, hydrolysis resistance and processability.

The amount of the cyclic amino terminal can be measured using 1H-NMR. Examples include a method in which the amount is calculated based on the integral ratio of hydrogen bound to carbon adjacent to a nitrogen atom of a nitrogen heterocyclic ring to hydrogen bound to carbon adjacent to a nitrogen atom of an amide bond in the polyamide main chain.

The cyclic amino terminal can be generated by the dehydration reaction of a cyclic amine with the carboxylic acid terminal, can also be generated by the deammoniation reaction of the amino terminal in the polymer molecular, can also be generated by adding a cyclic amine as the terminal blocking agent, or can also be generated by the deammoniation reaction of a diamine having a pentamethylenediamine backbone as a raw material of the polyamide.

In the present embodiment, the cyclic amino terminal is preferably derived from the diamine as a raw material.

When the cyclic amino terminal is generated from the diamine as a raw material without addition of any cyclic amine as the terminal blocking agent at the initial stage of polymerization, a low molecular weight carboxylic acid terminal tends to be avoided from being blocked at the initial stage of polymerization, to keep the polymerization reaction rate of the polyamide high, resulting in easy production of a high molecular weight substance. When a cyclic amine is thus generated in the middle of the reaction, the carboxylic acid terminal is blocked by the cyclic amine at the later stage of polymerization and therefore a high molecular weight polyamide is easily obtained.

The cyclic amine that generates the cyclic amino terminal can be generated as a by-product in the polymerization reaction of the polyamide. In the generation reaction of the cyclic amine, as the reaction temperature is higher, the reaction rate is also enhanced. Accordingly, in order that the amount of the cyclic amino terminal of the polyamide (A) is constant, generation of the cyclic amine is preferably promoted. Therefore, the polymerization reaction temperature with respect to the polyamide is preferably 300°C or higher, further preferably 320°C or higher.

The method of adjusting the amount of the cyclic amino terminal to a certain amount includes a method in which the amount is controlled by appropriately adjusting the polymerization temperature, the time during which the reaction temperature is 300°C or higher in the polymerization step, the amount of the amine forming the cyclic structure, to be added, and the like.

The terminal 4) by a blocking agent is a terminal formed in the case of addition of the blocking agent in polymerization. The blocking agent includes the terminal blocking agents described above.

Other terminal 5) is a polymer terminal not classified to the terminals 1) to 4) above, and includes a terminal generated by the deammoniation reaction of the amino terminal, and a terminal generated by the decarboxylation reaction from the carboxylic acid terminal.

<Properties of polyamide (A)>

The sulfuric acid relative viscosity ηr at 25°C can be utilized as an index of the molecular weight of the polyamide (A). As the ηr is higher, the molecular weight of the polyamide (A) is higher, and as the ηr is lower, the molecular weight of the polyamide (A) is lower.

The sulfuric acid relative viscosity ηr at 25°C of the polyamide (A) is preferably 1.5 to 7.0, more preferably 1.7 to 6.0, further preferably 1.9 to 5.5.

When the sulfuric acid relative viscosity ηr is within the above range, a polyamide composition more excellent in mechanical properties such as toughness and rigidity, and moldability and the like tends to be obtained. Herein, the sulfuric acid relative viscosity ηr at 25°C can be measured under a condition of a concentration of 1% in 98% sulfuric acid according to JIS-K6920. More specifically, the sulfuric acid relative viscosity ηr at 25°C can be measured by a method described in Examples later.

The melting point Tm2 of the polyamide (A) is preferably 270°C or higher, more preferably 275°C or higher, further preferably 280°C or higher.

In addition, the melting point Tm2 of the polyamide (A) is preferably 350°C or lower, more preferably 340°C or lower, further preferably 335°C or lower, more further preferably 330°C or lower.

When the melting point Tm2 of the polyamide (A) is 270°C or higher, a polyamide composition more excellent in heat resistance tends to be able to be obtained.

In addition, when the melting point Tm2 of the polyamide (A) is 350°C or lower, the polyamide (A) tends to be more inhibited from being pyrolyzed in melt processing such as extrusion and molding.

The melting point Tm2 of the polyamide (A) can be measured by a method described in Examples later, according to JIS-K7121.

The amount of heat of fusion, ΔH, of the polyamide (A) is preferably 10 J/g or more, more preferably 14J/g or more, further preferably 18J/g or more, more further preferably 20 J/g or more. The upper limit of the amount of heat of fusion, ΔH, is not particularly limited, and a higher upper limit is preferable.

When the amount of heat of fusion, ΔH, of the polyamide (A) is 10 J/g or more, heat resistance of the polyamide composition tends to be more enhanced.

The amount of heat of fusion, ΔH, of the polyamide (A) can be measured by a method described in Examples later, according to JIS-K7121.

Examples of the measurement apparatus of each of the melting point Tm2 and the amount of heat of fusion, ΔH, of the polyamide (A) include Diamond-DSC manufactured by PerkinElmer Co., Ltd.

The glass transition temperature Tg of the polyamide (A) is preferably 90°C or higher, more preferably 110°C or higher, further preferably 120°C or higher, still more preferably 130°C or higher, more further preferably 135°C or higher.

In addition, the glass transition temperature of the polyamide (A) is preferably 170°C or lower, more preferably 165°C or lower, further preferably 160°C or lower.

When the glass transition temperature of the polyamide (A) is 90°C or higher, a polyamide composition excellent in heat discoloration resistance and chemical resistance tends to be able to be obtained. When the glass transition temperature of the polyamide (A) is 170°C or lower, a molded article good in appearance tends to be able to be obtained.

The glass transition temperature of the polyamide (A) can be measured according to JIS-K7121 as described in Examples later.

Examples of the measurement apparatus of the glass transition temperature include Diamond-DSC manufactured by PerkinElmer Co., Ltd.

(Titanium oxide (B))

The polyamide composition of the present embodiment may also further contain a titanium oxide (B).

Examples of the titanium oxide (B) include, but not limited to the following, titanium oxide (TiO), dititanium trioxide ($Ti_2O_3$) and titanium dioxide ($TiO_2$).

Among them, titanium dioxide is preferable.

The crystal structure of the titanium oxide (B) is not particularly limited, but is preferably of a rutile type in terms of light resistance of the polyamide composition.

The titanium oxide (B) is preferably particulate, and the number average particle size of the titanium oxide (B) is preferably 0.1 to 0.8 μm, more preferably 0.15 to 0.4 μm, further preferably 0.15 to 0.3 μm.

When the number average particle size of the titanium oxide (B) is 0.1 μm or more, extrusion processability of the polyamide composition tends to be more enhanced.

When the number average particle size of the titanium oxide (B) is 0.8 μm or less, toughness of the polyamide composition tends to be more enhanced.

The number average particle size of the titanium oxide (B) can be measured by an electron micrographic method. For example, the number average particle size of the titanium oxide (B) can be determined by placing the polyamide composition in an electric furnace, subjecting organics included in the polyamide composition to an incineration treatment, observing 100 or more particles of the titanium oxide arbitrarily selected in the residue, by an electron microscope, and measuring the particle sizes of these particles.

Examples of the method for producing the titanium oxide (B) include, but not limited to the following, a so-called sulfuric acid method in which a titanium sulfate solution is hydrolyzed, or a so-called chlorine method in which a titanium halide is subjected to gas phase oxidation.

The titanium oxide (B) preferably has an inorganic coating layer and/or an organic coating layer on the surface thereof.

In particular, a titanium oxide (B) is preferable which has an inorganic coating layer on the surface thereof and which has an organic coating layer on the inorganic coating layer.

The particle of the titanium oxide (B) may also be coated using any known method.

Examples of the inorganic coating include, but not limited to the following, a metal oxide.

The organic coating preferably includes, but not limited to the following, for example, at least one organic substance selected from the group consisting of carboxylic acids, polyols, alkanolamines and an organosilicon compound.

In particular, the surface of the particle of the titanium oxide (B) is more preferably coated with polyols or an

organosilicon compound in terms of light resistance and extrusion processability of the polyamide composition, and is further preferably coated with an organosilicon compound from the viewpoint of a reduction in the amount of a gas to be generated in processing of the polyamide composition.

Herein, the titanium oxide (B) may be used singly or in combinations of two or more.

The content of the titanium oxide (B) in the polyamide composition of the present embodiment is preferably 5% by mass to 70% by mass, more preferably 20 to 70% by mass, further preferably 25 to 60% by mass, still more preferably 30 to 50% by mass based on 100% by mass of the polyamide composition.

When the content of the titanium oxide (B) is within the above range, the polyamide composition tends to be more excellent in whiteness.

(Metal hydroxide (C))

The polyamide composition of the present embodiment contains a metal hydroxide (C) and/or a metal oxide (D) described later.

The metal hydroxide (C) contained in the polyamide composition of the present invention is calcium hydroxide. Calcium hydroxide is more preferable from the viewpoint that the polyamide composition of the present embodiment is excellent in reflow resistance, extrusion stability and molding stability.

The metal hydroxide (C) may be used singly or in combinations of two or more.

Such a metal hydroxide (C) may also be used with being subjected to a surface treatment for the purpose of enhancements in adhesiveness and dispersibility.

Examples of a surface treatment agent include, but not limited to the following, silane coupling agents such as aminosilane and epoxysilane, and organosilicon compounds such as silicone; organotitanium compounds such as a titanium coupling agent; and organic substances such as an organic acid and a polyol.

(Metal oxide (D))

The metal oxide (D) contained in the polyamide composition of the present invention is calcium oxide. Calcium oxide is more preferable from the viewpoint that the polyamide composition of the present embodiment is excellent in heat discoloration resistance, extrusion stability and molding stability.

The metal oxide (D) may be used singly or as a mixture of two or more.

Such a metal oxide may also be used with being subjected to a surface treatment for the purpose of enhancements in adhesiveness and dispersibility.

Examples of the surface treatment agent include, but not limited to the following, silane coupling agents such as aminosilane and epoxysilane, and organosilicon compounds such as silicone; organotitanium compounds such as a titanium coupling agent; and organic substances such as an organic acid and a polyol.

The metal hydroxide (C) and/or the metal oxide (D) in the polyamide composition of the present embodiment preferably has a particle shape, and the average particle size is preferably 0.05 to 10 $\mu$m, more preferably 0.1 to 5 $\mu$m. When the average particle size is within the above range, the effects of reflow resistance and heat discoloration resistance are exerted in the polyamide composition.

The mass rate of particles having a size of 30 $\mu$m or more in all the particles of the metal hydroxide (C) and/or the metal oxide (D) is preferably 1% by mass or less, more preferably 0.1% by mass or less.

When the mass rate of particles having a size of 30 $\mu$m or more in all the particles of the metal hydroxide (C) and/or the metal oxide (D) is within the above range, the effects of reflow resistance and heat discoloration resistance are exerted in the polyamide composition.

The purity of the metal hydroxide (C) and/or the metal oxide (D) in the polyamide composition is preferably 99% or more, more preferably 99.5% or more, further preferably 99.9% or more. When the purity is high, the polyamide composition tends to be excellent in whiteness, reflow resistance and light discoloration resistance.

The content of the metal hydroxide (C) and/or the metal oxide (D) is 0.1 to 20% by mass, preferably 0.1 to 10% by mass, more preferably 0.3 to 5% by mass, further preferably 0.3 to 2% by mass, still more preferably 0.5 to 1.5% by mass, more further preferably 0.5 to 1.0% by mass based on 100% by mass of the polyamide composition.

When the content of the metal hydroxide (C) and/or the metal oxide (D) is within the above range, the polyamide composition tends to be more excellent in heat discoloration resistance, extrusion stability and molding stability.

The polyamide composition of the present embodiment may also further contain a metal compound other than the metal hydroxide (C) and/or the metal oxide (D) in terms of whiteness and heat discoloration resistance.

Examples of the metal compound other than the metal hydroxide (C) and the metal oxide (D) include, but not limited to the following, metal carbonates and metal halides.

The metal element included in the metal compound other than the metal hydroxide (C) and the metal oxide (D) is, but not particularly limited, for example, preferably a mono- or higher valent metal element. Examples of such a metal

element include, but not limited to the following, sodium, potassium, lithium, calcium, magnesium, barium, zinc, aluminum and strontium. The metal element is preferably an alkaline earth metal.

While the metal hydroxide (C) and/or the metal oxide (D) may also be added in polymerization of the polyamide (A), the metal hydroxide (C) and/or the metal oxide (D) is preferably added in production of the polyamide composition to be mixed with the polyamide (A), after polymerization of the polyamide (A). The metal hydroxide (C) and/or the metal oxide (D) is added in production of the polyamide composition, and thus heat history can be low and the metal hydroxide (C) and/or the metal oxide (D) can be inhibited from being, for example, decomposed, providing a polyamide composition excellent in whiteness, reflow resistance, heat discoloration resistance, extrusion processability and molding stability.

(Phosphorus-based compound (E))

The polyamide composition of the present embodiment contains a phosphorus-based compound (E).

Examples of the phosphorus-based compound (E) include, but not limited to the following, 1) phosphoric acid, phosphorous acid, hypophosphorous acid, and intramolecular and/or intermolecular condensation products thereof, and 2) metal salts of phosphoric acid, phosphorous acid, hypophosphorous acid, and intramolecular and/or intermolecular condensation products thereof.

Herein, the phosphorus-based compound (E) may be used singly or in combinations of two or more.

Examples of the 1) phosphoric acid, phosphorous acid, hypophosphorous acid, and intramolecular and/or intermolecular condensation products thereof, but not limited to the following, phosphoric acid, pyrophosphoric acid, metaphosphoric acid, phosphorous acid, hypophosphorous acid, pyrophosphorous acid and diphosphorous acid.

Examples of the 2) metal salts of phosphoric acid, phosphorous acid, hypophosphorous acid, and intramolecular and/or intermolecular condensation products thereof include, but not limited to the following, salts of the phosphorus-based compounds 1) with Group 1 and Group 2 elements in the periodic table, and manganese, zinc and aluminum.

A more preferable phosphorus-based compound (E) is one or more selected from the group consisting of a phosphoric acid metal salt, a phosphorous acid metal salt and a hypophosphorous acid metal salt, and intramolecular condensation products of such metal salts and intermolecular condensation products of such metal salts. When such a phosphorus-based compound (E) is used, the polyamide composition of the present embodiment tends to be more excellent in whiteness, heat discoloration resistance, heat reflow resistance and light discoloration resistance.

A further preferable phosphorus-based compound (E) is a metal salt including a phosphorus compound selected from phosphoric acid, phosphorous acid and hypophosphorous acid, and a metal selected from Group 1 elements (alkali metals) and Group 2 elements (alkaline earth metals) in the periodic table, manganese, zinc and aluminum, or an intramolecular condensation product of such a metal salt or an intermolecular condensation product of such a metal salt.

A further more preferable phosphorus-based compound (E) is a metal salt including a phosphorus compound selected from phosphoric acid, phosphorous acid and hypophosphorous acid, and a metal selected from Group 1 and Group 2 elements in the periodic table.

Examples of such a metal salt as the phosphorus-based compound (E) include, but not particularly limited, monosodium phosphate, disodium phosphate, trisodium phosphate, monocalcium phosphate, dicalcium phosphate, tricalcium phosphate, sodium pyrophosphate, sodium metaphosphate, calcium metaphosphate, sodium hypophosphate and calcium hypophosphate; anhydrous salts thereof; and hydrates thereof.

Among them, sodium hypophosphate, calcium hypophosphate and magnesium hypophosphate are preferable, and calcium hypophosphate and magnesium hypophosphate that are alkaline earth metal salts are more preferable. When such a phosphorus-based compound (E) is used, whiteness, heat discoloration resistance, light discoloration resistance and extrusion processability tend to be more excellent.

The phosphorus-based compound (E) selected from the group consisting of a phosphoric acid metal salt, a phosphorous acid metal salt and a hypophosphorous acid metal salt, and intramolecular condensation products of such metal salts and intermolecular condensation products of such metal salts is more preferably a hypophosphorous acid metal salt. When the phosphorus-based compound (E) is a hypophosphorous acid metal salt, a polyamide composition excellent in extrusion processability and molding stability can be obtained.

The metal element of the phosphorus-based compound (E) selected from the group consisting of a phosphoric acid metal salt, a phosphorous acid metal salt and a hypophosphorous acid metal salt, and intramolecular condensation products of such metal salts and intermolecular condensation products of such metal salts is preferably the same as the metal element of the metal hydroxide (C) and/or the metal oxide (D).

In particular, the metal element of the phosphorus-based compound (E) is preferably an alkaline earth metal.

When the phosphorus-based compound (E) is selected from the group consisting of a metal salt, an intramolecular condensation product of such a metal salt and an intermolecular condensation product of such a metal salt, and the metal element of the phosphorus-based compound (E) is the same as the metal element of the metal hydroxide (C) and/or the metal oxide (D), a polyamide composition higher in heat stability, and excellent in extrusion processability and molding stability can be obtained. Furthermore, when an alkaline earth metal is used as the metal element of the

phosphorus-based compound (E), more excellent effects with respect to the above characteristics are achieved.

The phosphorus-based compound (E) selected from the group consisting of a phosphoric acid metal salt, a phosphorous acid metal salt and a hypophosphorous acid metal salt, and intramolecular condensation products of such metal salts and intermolecular condensation products of such metal salts is preferably a metal salt not including any anhydrous salt and any hydrate.

When the metal salt not including any anhydrous salt and any hydrate is used as the phosphorus-based compound (E), the amount of water to be generated in processing can be suppressed, and a reduction in the molecular weight of the polyamide and gas generation can be suppressed. In addition, when the metal salt not including any anhydrous salt and any hydrate is used as the phosphorus-based compound (E), a polyamide composition excellent in whiteness, reflow resistance, heat discoloration resistance, extrusion processability and molding stability can be obtained.

The phosphorus-based compound (E) selected from the group consisting of a phosphoric acid metal salt, a phosphorous acid metal salt and a hypophosphorous acid metal salt, and intramolecular condensation products of such metal salts and intermolecular condensation products of such metal salts is preferably a metal salt low in deliquescence, more preferably a metal salt having no deliquescence.

When the metal salt low in deliquescence is used as the phosphorus-based compound (E), a reduction in the molecular weight of the polyamide and gas generation in processing, which are caused due to deterioration in workability and an increase in the amounts of water in respective raw material components in mixing of such raw material components in production of the polyamide composition, can be suppressed. When the metal salt low in deliquescence is used, a polyamide composition excellent in whiteness, reflow resistance, heat discoloration resistance, extrusion processability and molding stability can be obtained.

The phosphorus-based compound (E) may also include an organophosphorus-based compound.

Examples of the organophosphorus-based compound include, but not limited to the following, a pentaerythritol type phosphite compound, trioctyl phosphite, trilauryl phosphite, tridecyl phosphite, octyl diphenyl phosphite, trisisodecyl phosphite, phenyl diisodecyl phosphite, phenyl di(tridecyl) phosphite, diphenyl isooctyl phosphite, diphenyl isodecyl phosphite, diphenyl (tridecyl) phosphite, triphenyl phosphite, tris(nonylphenyl) phosphite, tris(2,4-di-t-butylphenyl) phosphite, tris(2,4-di-t-butyl-5-methylphenyl) phosphite, tris(butoxyethyl) phosphite, 4,4'-butylidene-bis(3-methyl-6-t-butylphenyl-tetra-tridecyl)diphosphite, tetra(C12 to C15 mixed alkyl)-4,4'-isopropylidene diphenyl diphosphite, 4,4'-isopropylidenebis(2-t-butylphenyl)-di(nonylphenyl)phosphite, tris(biphenyl) phosphite, tetra(tridecyl)-1,1,3-tris(2-methyl-5-t-butyl-4-hydroxyphenyl)butane diphosphite, tetra(tridecyl)-4,4'-butylidenebis(3-methyl-6-t-butylphenyl)diphosphite, tetra(C1 to C15 mixed alkyl)-4,4'-isopropylidene diphenyl diphosphite, tris(mono- and di- mixed nonylphenyl) phosphite, 9,10-di-hydro-9-oxa-9-oxa-10-phosphaphenanthrene-10-oxide, tris(3,5-di-t-butyl-4-hydroxyphenyl)phosphite, hydrogenated-4,4'-isopropylidene diphenyl polyphosphite, bis(octylphenyl)-bis(4,4'-butylidenebis(3-methyl-6-t-butylphenyl))-1,6-hexanol diphosphite, hexatridecyl-1,1,3-tris(2-methyl-4-hydroxy-5-t-butylphenyl)diphosphite, tris(4,4'-isopropylidenebis(2-t-butylphenyl))phosphite, tris(1,3-stearoyloxyisopropyl)phosphite, 2,2-methylenebis(4,6-dit-butylphenyl)octyl phosphite, 2,2-methylenebis(3-methyl-4,6-di-t-butylphenyl)2-ethylhexyl phosphite, tetrakis (2,4-di-t-butyl-5-methylphenyl)-4,4'-biphenylene diphosphate and tetrakis (2,4-di-t-butylphenyl)-4,4'-biphenylene diphosphite.

The organophosphorus-based compound may be used singly or in combinations of two or more.

Among the organophosphorus-based compounds recited above, a pentaerythritol type phosphite compound and tris(2,4-di-t-butylphenyl)phosphite are preferable and a pentaerythritol type phosphite compound is more preferable from the viewpoints of a further enhancement in heat aging resistance of the polyamide composition and a reduction in the amount of a gas to be generated.

Examples of the pentaerythritol type phosphite compound include, but not limited to the following, 2,6-di-t-butyl-4-methylphenyl-phenyl-pentaerythritol diphosphite, 2,6-di-t-butyl-4-methylphenyl-methyl-pentaerythritol diphosphite, 2,6-di-t-butyl-4-methylphenyl-2-ethylhexyl-pentaerythritol diphosphite, 2,6-di-t-butyl-4-methylphenyl-isodecyl-pentaerythritol diphosphite, 2,6-di-t-butyl-4-methylphenyl-lauryl - pentaerythritol diphosphite, 2,6-di-t-butyl-4-methylphenyl-isotridecyl-pentaerythritol diphosphite, 2,6-di-t-butyl-4-methylphenyl-stearyl-pentaerythritol diphosphite, 2,6-di-t-butyl-4-methylphenyl-cyclohexyl-pentaerythritol diphosphite, 2,6-di-t-butyl-4-methylphenyl-benzyl-pentaerythritol diphosphite, 2,6-dit-butyl-4-methylphenyl-ethylcellosolve-pentaerythritol diphosphite, 2,6-di-t-butyl-4-methylphenyl-butylcarbitol-pentaerythritol diphosphite, 2,6-di-t-butyl-4-methylphenyl-octylphenyl-pentaerythritol diphosphite, 2,6-di-t-butyl-4-methylphenyl-nonylphenyl-pentaerythritol diphosphite, bis(2,6-di-t-butyl-4-methylphenyl)pentaerythritol diphosphite, bis(2,6-di-t-butyl-4-ethylphenyl)pentaerythritol diphosphite, 2,6-dit-butyl-4-methylphenyl-2,6-di-t-butylphenyl-pentaerythritol diphosphite, 2,6-di-t-butyl-4-methylphenyl-2,4-di-t-butylphenyl-pentaerythritol diphosphite, 2,6-di-t-butyl-4-methylphenyl-2,4-di-t-octylphenyl-pentaerythritol diphosphite, 2,6-di-t-butyl-4-methylphenyl-2-cyclohexylphenyl-pentaerythritol diphosphite, 2,6-di-t-amyl-4-methylphenyl-phenyl-pentaerythritol diphosphite, bis(2,6-di-t-amyl-4-methylphenyl)pentaerythritol diphosphite, bis(2,6-di-t-octyl-4-methylphenyl)pentaerythritol diphosphate and bis(2,4-dicumylphenyl)pentaerythritol diphosphite.

The pentaerythritol type phosphite compound may be used singly or in combinations of two or more.

Among the pentaerythritol type phosphite compounds recited above, bis(2,6-di-t-butyl-4-methylphenyl)pentaerythritol diphosphite, bis(2,6-di-t-butyl-4-ethylphenyl)pentaerythritol diphosphite, bis(2,6-di-t-amyl-4-methylphenyl)pentaerythritol diphosphite, bis(2,6-di-t-octyl-4-methylphenyl)pentaerythritol diphosphate and bis(2,4-dicumylphenyl)pentaerythritol diphosphate are preferable.

The content of the phosphorus-based compound (E) in the polyamide composition of the present embodiment is 0.1 to 20.0% by mass based on 100% by mass of the polyamide composition. The content is preferably 0.2 to 7.0% by mass, more preferably 0.5 to 3.0% by mass, further preferably 0.5 to 2.5% by mass, still more preferably 0.5 to 2.0% by mass, more further preferably 0.5 to 1.5% by mass.

The polyamide composition of the present embodiment preferably contains the phosphorus-based compound (E) in a higher content than the content of the metal hydroxide (C) and/or the metal oxide (D).

When the content of the phosphorus-based compound (E) is within the above range, the polyamide composition of the present embodiment tends to be excellent in whiteness, reflow resistance, heat discoloration resistance, extrusion stability and molding stability.

The phosphorus-based compound (E) is preferably included in the polyamide composition of the present embodiment in a phosphorus element concentration of 1,400 to 20,000 ppm based on the polyamide composition, more preferably in a phosphorus element concentration of 2,000 to 20,000 ppm, further preferably 3,000 to 20,000 ppm, still more preferably 3,000 to 10,000 ppm, more further preferably 4,000 to 6,000 ppm.

When the phosphorus element concentration derived from the phosphorus-based compound (E) included in the polyamide composition is within the above range, the polyamide composition is excellent in whiteness, reflow resistance, heat discoloration resistance, extrusion stability and molding stability.

Herein, the phosphorus element concentration derived from the phosphorus-based compound (E) included in the polyamide composition can be measured by a method of measuring a metal element concentration described in Examples later.

While the phosphorus-based compound (E) may also be added in polymerization of the polyamide (A), the phosphorus-based compound (E) is preferably added in production of the polyamide composition to be mixed with the metal hydroxide (C) and/or the metal oxide (D), after polymerization of the polyamide (A). The phosphorus-based compound (E) is added in production of the polyamide composition, and thus heat history can be low and the phosphorus-based compound (E) can be inhibited from being, for example, decomposed, providing a polyamide composition excellent in whiteness, reflow resistance, heat discoloration resistance, extrusion processability and molding stability.

The metal hydroxide (C) and/or the metal oxide (D), and the phosphorus-based compound (E) are preferably included in the polyamide composition of the present embodiment in amounts so that the total value (excluding a phosphorus element) of the metal element concentrations derived from such components is 1,000 to 40,000 ppm, more preferably 2,000 to 30,000 ppm, further preferably 3,000 to 25,000 ppm, still more preferably 4,000 to 20,000 ppm, more further preferably 5,000 to 10,000 ppm.

When the metal element concentrations are within the above range, the polyamide composition tends to be more excellent in reflow resistance and light discoloration resistance.

Herein, the metal element concentrations can be measured by a method of measuring a metal element concentration described in Examples later.

(Phenol-based antioxidant and/or amine-based antioxidant)

The polyamide composition of the present embodiment may also contain a phenol-based antioxidant and/or an amine-based antioxidant in terms of heat stability.

Examples of the phenol-based antioxidant include, but not limited to the following, a hindered phenol compound. The phenol-based antioxidant, in particular, a hindered phenol compound has a property that imparts heat resistance and light resistance to resins of polyamide and the like, and fibers.

Examples of the hindered phenol compound include, but not limited to the following, N,N'-hexane-1,6-diylbis[3-(3,5-di-t-butyl-4-hydroxyphenylpropionamide), pentaerythrityl-tetrakis[3-(3,5-di-t-butyl-4-hydroxyphenyl)propionate], N,N'-hexamethylenebis(3,5-dit-butyl-4-hydroxy-hydrocinnamamide), triethylene glycol-bis[3-(3-t-butyl-5-methyl-4-hydroxyphenyl)propionate], 3,9-bis{2-[3-(3-t-butyl-4-hydroxy-5-methylphenyl)propynyloxy]-1,1-dimethylethyl}-2, 4, 8, 10-tetraoxaspiro[5,5]undecane, 3,5-di-t-butyl-4-hydroxybenzyl phosphonate-diethyl ester, 1,3,5-trimethyl-2,4,6-tris(3,5-di-t-butyl-4-hydroxybenzyl)benzene and 1,3,5-tris(4-t-butyl-3-hydroxy-2,6-dimethylbenzyl)isocyanuric acid.

Among them, N,N'-hexane-1,6-diylbis[3-(3,5-di-t-butyl-4-hydroxyphenylpropionamide)] is preferable as the hindered phenol compound from the viewpoint of an enhancement in heat aging resistance.

Herein, the phenol-based antioxidant may be used singly or in combinations of two or more.

The content of the phenol-based antioxidant in the polyamide composition of the present embodiment is preferably 0 to 1% by mass, more preferably 0.01 to 1% by mass, further preferably 0.1 to 1% by mass based on 100% by mass of the polyamide composition.

When the content of the phenol-based antioxidant is within the above range, the polyamide composition of the

present embodiment tends to be more excellent in heat aging resistance and lower in the amount of a gas to be generated.

Examples of the amine-based antioxidant include, but not limited to the following, aromatic amines such as poly(2,2,4-trimethyl-1,2-dihydroquinoline, 6-ethoxy-1,2-dihydro-2,2,4-trimethylquinoline, phenyl-α-naphthylamine, 4,4-bis(α,α-dimethylbenzyl)diphenylamine, (p-toluenesulfonylamide)diphenylamine, N,N'-diphenyl-p-phenylenediamine, N,N'-di-β-naphthyl-p-phenylenediamine, N,N'-di(1,4-dimethylpentyl)-p-phenylenediamine, N-phenyl-N'-isopropyl-p-phenylenediamine, N-phenyl-N'-1,3-dimethylbutyl-p-phenylenediamine and N-(1-methylheptyl)-N'-phenyl-p-phenylenediamine.

In the present embodiment, the amine-based antioxidant includes an aromatic amine-based compound. The amine-based antioxidant may be used singly or in combinations of two or more.

The content of the amine-based antioxidant in the polyamide composition of the present embodiment is preferably 0 to 1% by mass, more preferably 0.01 to 1% by mass, further preferably 0.1 to 1% by mass based on 100% by mass of the polyamide composition.

When the content of the amine-based antioxidant is within the above range, the polyamide composition tends to be more excellent in heat aging resistance and lower in the amount of a gas to be generated.

(Inorganic filler (F))

The polyamide composition of the present embodiment may also further contain an inorganic filler (F) other than the titanium oxide (B) in terms of mechanical properties such as strength and rigidity.

Examples of the inorganic filler (F) include, but not limited to the following, glass fiber, carbon fiber, calcium silicate fiber, potassium titanate fiber, aluminum borate fiber, glass flake, talc, kaolin, mica, hydrotalcite, calcium carbonate, zinc carbonate, zinc oxide, wollastonite, silica, zeolite, alumina, boehmite, aluminum hydroxide, silicon oxide, calcium silicate, sodium aluminosilicate, magnesium silicate, carbon nanotube, graphite, brass, copper, silver, aluminum, nickel, iron, calcium fluoride, montmorillonite, and swellable fluorine mica.

Among them, the inorganic filler (F) is preferably one or more selected from the group consisting of glass fiber, potassium titanate fiber, talc, wollastonite, kaolin, mica and calcium carbonate, more preferably wollastonite and calcium carbonate.

The number average particle size of the inorganic filler (F) is preferably 0.1 to 0.8 μm, more preferably 0.15 to 0.4 μm, further preferably 0.15 to 0.3 μm in terms of whiteness, toughness and extrusion processability of the polyamide composition.

When such an inorganic filler (F) is included, the polyamide composition of the present embodiment tends to be more excellent in mechanical strength, appearance, whiteness, and the like.

The inorganic filler (F) may be used singly or in combinations of two or more.

The content of the inorganic filler (F) in the polyamide composition of the present embodiment is preferably 5 to 50% by mass, more preferably 10 to 50% by mass, further preferably 15 to 40% by mass based on 100% by mass of the polyamide composition.

When the content of the inorganic filler (F) is within the above range, the polyamide composition of the present embodiment can keep strength, rigidity and toughness in a well-balanced manner.

The content of the inorganic filler (F) is 5% by mass or more, preferably 10% by mass or more, more preferably 15% by mass or more from the above viewpoint.

(Amine-based light stabilizer)

The polyamide composition of the present embodiment may also further contain an amine-based light stabilizer in terms of light stability.

Examples of the amine-based light stabilizer include, but not limited to the following, 4-acetoxy-2,2,6,6-tetramethylpiperidine, 4-stearoyloxy-2,2,6,6-tetramethylpiperidine, 4-acryloyloxy-2,2,6,6-tetramethylpiperidine, 4-(phenylacetoxy)-2,2,6,6-tetramethylpiperidine, 4-benzoyloxy-2,2,6,6-tetramethylpiperidine, 4-methoxy-2,2,6,6-tetramethylpiperidine, 4-stearyloxy-2,2,6,6-tetramethylpiperidine, 4-cyclohexyloxy-2,2,6,6-tetramethylpiperidine, 4-benzyloxy-2,2,6,6-tetramethylpiperidine, 4-phenoxy-2,2,6,6-tetramethylpiperidine, 4-(ethylcarbamoyloxy)-2,2,6,6-tetramethylpiperidine, 4-(cyclohexylcarbamoyloxy)-2,2,6,6-tetramethylpiperidine, 4-(phenylcarbamoyloxy)-2,2,6,6-tetramethylpiperidine, bis(2,2,6,6-tetramethyl-4-piperidyl)carbonate, bis(2,2,6,6-tetramethyl-4-piperidyl)oxalate, bis(2,2,6,6-tetramethyl-4-piperidyl)malonate, bis(2,2,6,6-tetramethyl-4-piperidyl)sebacate, bis(2,2,6,6-tetramethyl-4-piperidyl)adipate, bis(2,2,6,6-tetramethyl-4-piperidyl)terephthalate, bis(1,2,2,6,6-pentamethyl-4-piperidyl)carbonate, bis(1,2,2,6,6-pentamethyl-4-piperidyl)oxalate, bis(1,2,2,6,6-pentamethyl-4-piperidyl)malonate, bis(1,2,2,6,6-pentamethyl-4-piperidyl)sebacate, bis(1,2,2,6,6-pentamethyl-4-piperidyl)adipate, bis(1,2,2,6,6-pentamethyl-4-piperidyl)terephthalate, N,N'-bis-2,2,6,6-tetramethyl-4-piperidinyl-1,3-benzenedicarboxyamide, 1,2-bis(2,2,6,6-tetramethyl-4-piperidyloxy)ethane, α,α'-bis(2,2,6,6-tetramethyl-4-piperidyloxy)-p-xylene, bis(2,2,6,6-tetramethyl-4-piperidyltolylene-2,4-dicarbamate,

bis(2,2,6,6-tetramethyl-4-piperidyl)-hexamethylene-1,6-dicarbamate, tris(2,2,6,6-tetramethyl-4-piperidyl)-benzene-1,3,5-tricarboxylate, N,N',N'',N'''-tetrakis-(4,6-bis-(butyl-(N-methyl-2,2,6,6-tetramethylpiperidine-4-yl)amino)-triazine-2-yl)-4,7-diazadecane-1,10-diamine, a polycondensation product of dibutylamine-1,3,5-triazine-N,N'-bis(2,2,6,6-tetramethyl-4-piperidyl)-1,6-hexamethylenediamine and N-(2,2,6,6-tetramethyl-4-piperidyl)butylamine, poly[{6-(1,1,3,3-tetramethylbutyl)amino-1,3,5-triazine-2,4-diyl}{ (2,2,6,6-tetramethyl-4-piperidyl)imino}hexamethylene{ (2,2,6,6-tetramethyl-4-piperidyl)imino}], tetrakis (2,2,6,6-tetramethyl-4-piperidyl)-1,2,3,4-butanetetracarboxylate, tetrakis(1,2,2,6,6-pentamethyl-4-piperidyl)-1,2,3,4-butanetetracarboxylate, tris(2,2,6,6-tetramethyl-4-piperidyl)-benzene-1,3,4-tricarboxylate, 1-[2-{3-(3,5-dit-butyl-4-hydroxyphenyl)propionyloxy}butyl]-4-[3-(3,5-dit-butyl-4-hydroxyphenyl)propionyloxy]2,2,6,6-tetramethylpiperidine, and a condensation product of 1,2,3,4-butanetetracarboxylic acid, 1,2,2,6,6-pentamethyl-4-piperidinol and β,β,β',β'-tetramethyl-3,9-[2,4,8,10-tetraoxaspiro(5,5)undecane]diethanol.

The amine-based light stabilizer may be used singly or in combinations of two or more.

The amine-based light stabilizer is preferably bis(2,2,6,6-tetramethyl-4-piperidyl)carbonate, bis(2,2,6,6-tetramethyl-4-piperidyl)oxalate, bis(2,2,6,6-tetramethyl-4-piperidyl)malonate, bis(2,2,6,6-tetramethyl-4-piperidyl)sebacate, bis(2,2,6,6-tetramethyl-4-piperidyl)adipate, bis(2,2,6,6-tetramethyl-4-piperidyl)terephthalate, N,N'-bis-2,2,6,6-tetramethyl-4-piperidinyl-1,3-benzenedicarboxyamide or tetrakis (2,2,6,6-tetramethyl-4-piperidyl)-1,2,3,4-butanetetracarboxylate.

Among them, the amine-based light stabilizer is more preferably bis(2,2,6,6-tetramethyl-4-piperidyl)sebacate, N,N'-bis-2,2,6,6-tetramethyl-4-piperidinyl-1,3-benzenedicarboxyamide or tetrakis(2,2,6,6-tetramethyl-4-piperidyl)-1,2,3,4-butanetetracarboxylate, further preferably N,N'-bis-2,2,6,6-tetramethyl-4-piperidinyl-1,3-benzenedicarboxyamide.

The content of the amine-based light stabilizer in the polyamide composition of the present embodiment is preferably 0 to 2% by mass, more preferably 0.01 to 2% by mass, further preferably 0.1 to 2% by mass based on 100% by mass of the polyamide composition. When the content of the amine-based light stabilizer is within the above range, the polyamide composition can be further enhanced in light stability and heat aging resistance, and furthermore can be reduced in the amount of a gas to be generated.

(Nucleating agent)

The polyamide composition of the present embodiment preferably further contains a nucleating agent in terms of releasability.

The "nucleating agent" means a substance that exerts the effect of raising the crystallization temperature measured in differential scanning calorimetry (DSC) by addition thereof and/or the effect of miniaturization or size uniformizing of a spherocrystal of the resulting molded article.

Examples of the nucleating agent include, but not limited to the following, boron nitride, barium sulfate, silicon nitride, carbon black, and molybdenum disulfide.

The nucleating agent may be used singly or in combinations of two or more.

Among the above nucleating agents, talc, boron nitride and carbon black are preferable, talc and boron nitride are more preferable, and talc is further preferable in terms of the nucleating agent effect.

The nucleating agent preferably has a particle shape, and the number average particle size of the nucleating agent is preferably 0.01 to 10 μm, more preferably 0.5 to 5 μm, further preferably 0.5 to 3 μm.

When the number average particle size of the nucleating agent is within the above range, the nucleating effect tends to be more enhanced.

The number average particle size of the nucleating agent can be determined by dissolving a molded article of the polyamide composition of the present embodiment in a solvent that can dissolve the polyamide, such as formic acid, arbitrarily selecting, for example, 100 or more particles of the nucleating agent from the resulting insoluble component, and observing the particles by an optical microscope, a scanning electron microscope or the like.

The amount of the nucleating agent to be incorporated is preferably 0.001 to 15% by mass, more preferably 0.001 to 5% by mass, further preferably 0.001 to 3% by mass, still more preferably 0.5 to 2.5% by mass based on 100% by mass of the polyamide composition of the present embodiment.

When the amount of the nucleating agent to be incorporated is 0.001% by mass or more based on 100% by mass of the polyamide composition, the polyamide composition of the present embodiment is favorably enhanced in heat resistance, and when the amount to be incorporated is 15% by mass or less, a polyamide composition excellent in toughness can be obtained.

(Other component(s))

Other component(s) may be, if necessary, added to the polyamide composition of the present embodiment, in addition to the above components.

Examples of the other component(s) include, but not limited to the following, a colorant (including a coloring master batch) such as a pigment and a dye, a release agent, a flame retardant, a fibrillating agent, a lubricant, a fluorescent whitening agent, a plasticizer, a copper compound, an alkali metal halide compound, an antioxidant, a stabilizer, an ultraviolet absorber, an antistatic agent, a fluidity modifier, a filler, a reinforcing agent, a spreading agent, a nucleus agent, a rubber, a toughening agent and other polymer.
The other components described above are each largely different in properties, and therefore suitable content rates of the respective components are varied. Those skilled in the art can easily set a suitable content rate of each of other components described above.

[Method for producing polyamide composition]

A method for producing the polyamide composition of the present embodiment is not particularly limited, and a method of mixing respective raw material components including the polyamide (A), the metal hydroxide (C) and/or the metal oxide (D), the phosphorus-based compound (E), and further, if necessary, the titanium oxide (B), the phenol-based antioxidant and/or the amine-based antioxidant, the inorganic filler (F), the amine-based light stabilizer, the nucleating agent and other component(s) described above can be used.
When the polyamide composition of the present embodiment contains the titanium oxide (B), examples of the method of mixing the polyamide (A) and the titanium oxide (B) include, but not limited to the following, a method including mixing the polyamide (A) and the like with the titanium oxide (B) by use of a tumbler, a Henschel mixer or the like, and feeding the resulting mixture to a melt kneader and kneading it, and a method including compounding to the polyamide (A) and the like molten in a uniaxial or biaxial extruder, the titanium oxide (B) from a side feeder.
Also when the metal hydroxide (C) and/or the metal oxide (D), and the phosphorus-based compound (E) are incorporated, the same method can be used, and examples include a method including mixing the polyamide (A) and the like with the metal hydroxide (C) and/or the metal oxide (D), and the phosphorus-based compound (E), and feeding the resulting mixture to a melt kneader and kneading it, and a method including compounding to the polyamide (A) and the like molten in a uniaxial or biaxial extruder, the metal hydroxide (C) and/or the metal oxide (D), and the phosphorus-based compound (E) from a side feeder.
The method of mixing the metal hydroxide (C) and/or the metal oxide (D), and the phosphorus-based compound (E) is preferably a method including compounding them from a side feeder. When the method including compounding them from a side feeder is used to produce a polyamide composition, the polyamide composition tends to be excellent in whiteness, reflow resistance, heat discoloration resistance, light discoloration resistance and molding stability.
Also when the inorganic filler (F) is incorporated, the same method can be used, and examples include a method including mixing the polyamide (A) and the like with the inorganic filler (F), and feeding the resulting mixture to a melt kneader and kneading it, and a method including compounding to the polyamide (A) and the like molten in a uniaxial or biaxial extruder, the inorganic filler (F) from a side feeder.
The method of feeding respective constitutional components of the polyamide composition to a melt kneader may be a method of feeding all the constitutional components through the same feeding port, or may be a method of feeding the respective constitutional components through respective different feeding ports.
The melt kneading temperature is preferably 250 to 375°C in terms of the resin temperature. The melt kneading time is preferably 0.25 to 5 minutes.
The apparatus for performing melt kneading is not particularly limited, and a known apparatus, for example, a melt kneader such as a uniaxial or biaxial extruder, a Bunbury mixer and a mixing roll can be used.

[Physical properties of polyamide composition]

The sulfuric acid relative viscosity $\eta r$ at 25°C, the melting point Tm2, the amount of heat of fusion, $\Delta H$, and the glass transition temperature Tg of the polyamide composition of the present embodiment can be measured by the same methods as in the polyamide (A). Specifically, these can be measured by methods described in Examples later.
When the measurement values with respect to the polyamide composition are within the same ranges as preferable ranges of the measurement values with respect to the polyamide, a polyamide composition more excellent in heat resistance, moldability and chemical resistance can be obtained.
The crystallization peak temperature Tc (°C) of the polyamide composition of the present embodiment, obtained in cooling at 100°C/min, is preferably 240 to 290°C.
The crystallization peak temperature Tc (°C) of the polyamide composition is more preferably 245°C or higher, further preferably 250°C or higher, still more preferably 255°C or higher, more further preferably 260°C or higher. In addition, the crystallization peak temperature Tc (°C) of the polyamide composition is more preferably 280°C or lower, more preferably 275°C or lower, further preferably 270°C or lower.
When the crystallization peak temperature Tc (°C) of the polyamide composition is 240°C or higher, a polyamide

composition excellent in releasability in molding can be obtained. When the crystallization peak temperature Tc (°C) of the polyamide composition is 290°C or lower, a polyamide composition can be obtained which can be molded into a fine component such as a thin molded article with the gate seal in molding being not conducted at a too high rate.

Measurements of the melting point and the crystallization peak temperature Tc of the polyamide composition for use in the present embodiment can be conducted by a method described in Examples later, according to JIS-K7121.

Examples of the measurement apparatus of the crystallization peak temperature Tc include Diamond-DSC manufactured by PerkinElmer Co., Ltd.

The polyamide composition of the present embodiment preferably has a difference (Tc - Tg) between the crystallization peak temperature Tc (°C) and the glass transition temperature Tg, obtained in cooling at 100°C/min, of 90°C or higher, more preferably 95°C or higher, further preferably 100°C or higher, still more preferably 105°C or higher, more further preferably 110°C or higher.

It is meant that as the difference (Tc - Tg) between the crystallization peak temperature Tc (°C) and the glass transition temperature Tg of the polyamide composition of the present embodiment, obtained in cooling at 100°C/min, is larger, the temperature range in which crystallization can be conducted is wider and crystallization is more sufficiently easily conducted in the mold.

When the difference (Tc - Tg) between the crystallization peak temperature Tc (°C) and the glass transition temperature Tg of the polyamide composition of the present embodiment, obtained in cooling at 100°C/min, is 90°C or higher, the polyamide composition is excellent in releasability in molding. The upper limit of the difference (Tc - Tg) between the crystallization peak temperature Tc (°C) and the glass transition temperature Tg of the polyamide composition of the present embodiment, obtained in cooling at 100°C/min, is preferably 300°C or lower, but not particularly limited thereto.

[Molded article]

A molded article of the present embodiment includes the polyamide composition.

The molded article of the present embodiment is excellent in reflow resistance, heat discoloration resistance and light discoloration resistance, and can be suitably used for a reflective plate or the like.

The molded article of the present embodiment can be obtained by, for example, molding the polyamide composition by a known molding method.

Examples of the known molding method include, but not limited to the following, commonly known plastic molding methods such as press molding, injection molding, gas assist injection molding, welding molding, extrusion molding, blow molding, film molding, hollow molding, multilayer molding and melt spinning.

The molded article of the present embodiment includes the polyamide composition, and thus is excellent in heat resistance, moldability, mechanical strength and low water-absorption property. Accordingly, the polyamide composition can be suitably used in various component materials for automobiles, electric and electronics, industrial materials, and daily and household items, and can be suitably used for extrusion application and the like.

The molded article of the present embodiment preferably has a reflectance retention rate after exposure for 1000 hours by a metal halide lamp system light resistance tester at 100°C and at a position where the illuminance is 10 $mW/cm^2$, of 95% or more. The reflectance retention rate is more preferably 98% or more, further preferably 99% or more.

In order that the reflectance retention rate is 95% or more, it is effective that the phosphorus-based compound (E) be contained.

The reflectance retention rate of the molded article can be measured by a method described in Examples later.

The molded article of the present embodiment can be used in various component materials.

Examples of a component for automobiles include, but not limited to the following, an air intake system component, a cooling system component, a fuel system component, an interior component, an exterior component and an electrical component.

Examples of the automobile air intake system component include, but not limited to the following, an air intake manifold, an intercooler inlet, an exhaust pipe cover, an inner bushing, a bearing retainer, an engine mount, an engine head cover, a resonator and a throttle body.

Examples of the automobile cooling system component include, but not limited to the following, a chain cover, a thermostat housing, an outlet pipe, a radiator tank, an alternator and a delivery pipe.

Examples of the automobile fuel system component include, but not limited to the following, a fuel delivery pipe and a gasoline tank case.

Examples of the automobile interior component include, but not limited to the following, an instrument panel, a console box, a glove box, a steering wheel and a trim.

Examples of the automobile exterior component include, but not limited to the following, a molding, a lamp housing, a front grill, a mud guard, a side bumper, a door mirror stay and a roof rail.

Examples of the automobile electrical component include, but not limited to the following, a connector, a wire

harness connector, a motor component, a lamp socket, an on-board sensor switch and a combination switch.

Examples of a component for electric and electronics include, but not limited to the following, a connector, a switch, a relay, a printed wiring board, an electronic component housing, a power point, a noise filter, a coil bobbin, a reflector for LED, a reflective plate for LED and a motor end cap.

Examples of a component for industrial equipment include, but not limited to the following, a gear, a cam, an insulation block, a valve, an electric tool component, an agricultural implement component and an engine cover.

Examples of a component for daily and household items include, but not limited to the following, a button, a food container and office furniture.

Examples of a component for extrusion application include, but not limited to the following, a film, a sheet, a filament, a tube, a rod and a hollow molded article.

[Method of suppressing reduction in reflectance of reflective plate due to heat]

The molded article containing the polyamide composition of the present embodiment as described above can be suitably used as a reflective plate.

In the reflective plate, the polyamide (A), the metal hydroxide (C) and/or the metal oxide (D), and the phosphorus-based compound (E) can be used in combination to thereby effectively suppress a reduction in reflectance due to heat.

The reflectance can be measured by a method described in Examples later, and it is demonstrated in Examples described later that a reduction in reflectance can be effectively suppressed in the reflective plate containing the polyamide composition of the present embodiment using the above combination.

[Examples]

Hereinafter, the present invention is described in detail with reference to specific Examples and Comparative Examples, but the present invention is not intended to be limited to the following Examples.

Raw materials and measurement methods used in Examples and Comparative Examples are shown below.

In the present Examples, 1 $kg/cm^2$ means 0.098 MPa.

[Raw materials]

(Polyamide (A) (PA-1))

Polyamide (A) for use in each of the present Examples and Comparative Examples was produced by appropriately using the following (a) and (b).

<Dicarboxylic acid (a)>

(a-1) 1,4-Cyclohexanedicarboxylic acid (CHDA) (produced by Eastman Chemical Company, tradename: 1,4-CHDA HP grade (trans isomer/cis isomer = 25/75))
(a-2) Terephthalic acid (produced by Wako Pure Chemical Industries, Ltd.)

<Diamine (b)>

(b-1) 2-Methylpentamethylenediamine (2MC5DA) (produced by Tokyo Chemical Industries Co., Ltd.)
(b-2) 1,9-Nonamethylenediamine (C9DA) (produced by Sigma-Aldrich Co., Ltd.)
(b-3) 2-Methyloctamethylenediamine (2MC9DA) (produced with reference to the production method described in Japanese Patent Laid-Open No. 05-17413)

(Titanium oxide (B))

(B-1) $TiO_2$ (produced by Ishihara Sangyo Kaisha, Ltd, tradename: Taipake (registered trademark) CR-63, number average particle size: 0.21 μm, coating: alumina, silica and siloxane compounds)

Herein, the number average particle size of the titanium oxide (B) was measured as follows by an electron micrographic method.

The number average particle size of the titanium oxide (B) was determined by placing a polyamide composition in each of Examples and Comparative Examples described later in an electric furnace, subjecting organics included in the polyamide composition to an incineration treatment, observing 100 or more particles of the titanium oxide arbitrarily selected in the residue, by an electron microscope, and measuring the particle sizes of such particles.

(Metal hydroxide (C))

(C-1) Calcium hydroxide (purity: 99.9%) (produced by Wako Pure Chemical Industries, Ltd.)
(C-2) Magnesium hydroxide (purity: 99.9%) (produced by Wako Pure Chemical Industries, Ltd.)

(Metal oxide (D))

(D-1) Calcium oxide (purity: 99.9%) (produced by Wako Pure Chemical Industries, Ltd.)
(D-2) Magnesium oxide (Wako First Grade) (produced by Wako Pure Chemical Industries, Ltd.)

(Phosphorus-based compound (E))

(E-1) Calcium hypophosphate (produced by Wako Pure Chemical Industries, Ltd., decomposition starting temperature: 340°C)
(E-2) Sodium hypophosphate monohydrate (produced by Wako Pure Chemical Industries, Ltd., decomposition starting temperature: 300°C)

(Inorganic filler (F))

(F) Wollastonite (number average fiber diameter: 8 μm)

Herein, the number average fiber diameter of the inorganic filler (F) was determined by placing a polyamide composition in each of Examples and Comparative Examples described later in an electric furnace, subjecting organics included in the polyamide composition to an incineration treatment, observing 100 or more glass fibers arbitrarily selected in the residue, by an SEM, and measuring the fiber diameters of such glass fibers.

(Phenol-based antioxidant)

Phenol-based antioxidant (produced by BASF, tradename: IRGANOX (registered trademark) 1098)

(Silicone compound)

Epoxy-modified reactive silicone oil (produced by Shin-Etsu Chemical Co., Ltd., tradename: KF-105, viscosity (25°C): 15 $mm^2/s$, functional group equivalent = 490 g/mol)

(Nucleating agent)

Talc (produced by Nippon Talc Co., Ltd., tradename: MICRO ACE (registered trademark) L-1, average particle size: 5 μm)

[Method of identifying dicarboxylic acid unit in polyamide]

[Calculation of molar percentage (% by mol) of alicyclic dicarboxylic acid unit (a-1)]

The molar percentage (% by mol) of alicyclic dicarboxylic acid unit (a-1) was determined using the following formula by calculation.

Formula: Molar percentage (% by mol) of alicyclic dicarboxylic acid unit (a-1) = (Molar number of alicyclic dicarboxylic acid added as raw material monomer/Molar number of all dicarboxylic acids added as raw material monomers) × 100

[Calculation of molar percentage (% by mol) of aromatic dicarboxylic acid unit (a-2)]

The molar percentage (% by mol) of aromatic dicarboxylic acid unit (a-2) was determined using the following formula by calculation.

Formula: The molar percentage of aromatic dicarboxylic acid unit (a-2) = (Molar number of aromatic dicarboxylic acid added as raw material monomer/Molar number of all dicarboxylic acids added as raw material monomers) × 100

[Measurement methods of physical properties]

(1) Melting point Tm2 (°C), amount of heat of fusion, ΔH (J/g), and crystallization peak temperature Tc (°C) of polyamide

The melting point Tm2 (°C) and the amount of heat of fusion, ΔH (J/g), of each polyamide were measured using Diamond-DSC manufactured by PerkinElmer Co., Ltd. according to JIS-K7121.

Specifically, measurements were conducted as follows.

First, under a nitrogen atmosphere, about 10 mg of a sample was heated from room temperature to 300 to 350°C depending on the melting point of the sample at a temperature rise of 20°C/min. The temperature of the endothermic peak (fusion peak) appearing here was defined as Tm1 (°C). Next, the maximum temperature during temperature rise was kept for 2 minutes. The polyamide was molten at the maximum temperature. Thereafter, the sample was cooled to 30°C at a temperature drop of 100°C/min. The exothermic peak appearing here was defined as the crystallization peak, and the crystallization peak temperature was defined as Tc. Thereafter, the sample was held at 30°C for 2 minutes, and thereafter heated from 30°C to 300 to 350°C depending on the melting point of the sample at a temperature rise of 20°C/min. The maximum peak temperature of the endothermic peak (fusion peak) appearing here was defined as the melting point Tm2 (°C), and the total peak area was defined as the amount of heat of fusion, ΔH (J/g). When a plurality of peaks appeared, a peak at which the ΔH was 1J/g or more was adopted, and an endothermic peak having the maximum ΔH was defined as the melting point Tm2 (°C). For example, when two peaks, an endothermic peak temperature of 295°C (ΔH = 20 J/g) and an endothermic peak temperature of 325°C (ΔH = 25 J/g), were present, the melting point Tm2 was 325°C and the ΔH was 25 J/g.

(2) Trans isomer ratio of polyamide

The trans isomer ratio of a moisty derived from alicyclic dicarboxylic acid (a-1) in polyamide (A) was measured as follows.

The polyamide (30 to 40 mg) was dissolved in 1.2 g of deuterated hexafluoroisopropanol, and the resulting solution was used to measure the trans isomer ratio by 1H-NMR.

When alicyclic dicarboxylic acid (a-1) was 1,4-cyclohexanedicarboxylic acid, the trans isomer ratio was determined from the ratio of the peak area at 1.98 ppm derived from the trans isomer to the peak area at each of 1.77 ppm and 1.86 ppm derived from the cis isomer.

(3) Glass transition temperature Tg (°C) of polyamide

The glass transition temperature Tg (°C) was measured using Diamond-DSC manufactured by PerkinElmer Co., Ltd. according to JIS-K7121. Specifically, measurement was conducted as follows. A sample was molten on a hot stage (EP80 manufactured by Mettler-Toledo International Inc), and the resulting sample molten was quenched and solidified using liquid nitrogen to provide a measurement sample. Ten mg of the measurement sample was heated in the range from 30 to 350°C by the DSC under a condition of a temperature rise speed of 20°C/min, and the glass transition temperature Tg (°C) observed in such temperature rise was measured.

(4) Sulfuric acid relative viscosity $\eta r$ at 25°C of polyamide

Measurement of the sulfuric acid relative viscosity $\eta r$ at 25°C was performed according to JIS-K6810.

Specifically, a solution having a concentration of 1% (proportion of (1 g of polyamide)/(100 mL of 98% sulfuric acid)) was prepared using 98% sulfuric acid, and the resulting solution was used to measure the sulfuric acid relative viscosity $\eta r$ under a temperature condition of 25°C.

(5) Metal element concentration

The metal element concentrations derived from the metal hydroxide (C), the metal oxide (D) and the phosphorus-based compound (E) included in the polyamide composition were measured by ICP emission spectrometry (ICPS-8100 manufactured by Shimadzu Corporation), and the total value (excluding the phosphorus element) of the metal element concentrations derived from the components (C), (D) and (E) included in the polyamide composition, and the phosphorus element concentration derived from the component (E) included in the polyamide composition were calculated.

(6) Analysis method of metal compound

Measurement by XRD was conducted. As the measurement apparatus, X'Pert PRO MPD manufactured by PANalytical B.V. was used. As the detector, X'Celerator was used. The metal compound was identified from the diffraction pattern of the single metal compound. The content was calculated from the peak area in X-ray diffraction.

(7) Initial reflectance (%)

A polyamide composition produced in each of Examples and Comparative Examples described later was molded into a pellet by use of an injection molding machine [PS-40E: manufactured by Nissei Plastic Industrial Co., Ltd.], thereby preparing a molded piece of 60 mm in length × 60 mm in width × 1.0 mm in thickness.

In the molding, the time for injection and pressure keeping was set to 10 seconds, the cooling time was set to 15 seconds, the mold temperature was set to 120°C, and the temperature of the polyamide composition molten was set to a temperature higher than the melting point Tm2 of polyamide (A) by 10°C.

The reflectance of light at a wavelength of 450 nm of the resulting molded piece was measured by a Hitachi spectrophotometer (U-3310).

(8) Reflectance retention rate (%) after reflow step

A polyamide composition produced in each of Examples and Comparative Examples described later was molded into a pellet by use of an injection molding machine [PS-40E: manufactured by Nissei Plastic Industrial Co., Ltd.], thereby preparing a molded piece of 60 mm in length × 60 mm in width × 1.0 mm in thickness.

In the molding, the time for injection and pressure keeping was set to 10 seconds, the cooling time was set to 15 seconds, the mold temperature was set to 120°C, and the temperature of the polyamide composition molten was set to a temperature higher than the melting point Tm2 of polyamide (A) by 10°C. The resulting molded piece was subjected to a heating treatment (reflow step) in a hot air reflow furnace (280°C × 10 seconds) three times.

The reflectance of light at a wavelength of 450 nm of the molded piece each of before and after the heating treatment (reflow step) was measured by a Hitachi spectrophotometer (U-3310), and the reflectance retention rate after the reflow step was calculated.

(9) Reflectance retention rate (%) after heating treatment

The molded piece after the reflow step, obtained above, was subjected to a heating treatment in a hot air dryer at 150°C for 72 hours.

The reflectance of light at a wavelength of 450 nm of the molded piece after the heat treatment was measured by a Hitachi spectrophotometer (U-3310), and compared with the reflectance before the heat treatment to calculate the reflectance retention rate.

(10) Reflectance retention rate (%) in metal halide exposure test

The molded piece after the heat treatment, obtained in measurement of the reflectance retention rate (%) after the heat treatment, was subjected to a metal halide exposure treatment in a metal halide lamp system light resistance tester (manufactured by Iwasaki Electric Co., Ltd.) at 100°C for 1000 hours. The illuminance at a position where the molded piece was installed was 10 mW/cm$^2$.

The molded piece each of before and after the metal halide exposure treatment was irradiated with light at a wavelength of 450 nm, and the reflectance of the light was measured by a Hitachi spectrophotometer (U-3310) to calculate the reflectance retention rate.

(11) Extrusion processability

A polyamide composition produced in each of Examples and Comparative Examples described later was extruded by a biaxial extruder having a screw diameter of 26 mm, to provide a pellet.

In the extrusion, the cylinder temperature was set to a temperature higher than the melting point Tm2 of polyamide (A) by 20°C, the number of rotations of the screw was set to 300 rpm, and the amount to be discharged was set to 25 kg/h.

The number of strands cut, to be generated at 20 minutes after the initiation of the extrusion, was measured.

It was determined that as the number of the strands cut was smaller, extrusion processability was more excellent.

(12) Moldability

A polyamide composition produced in each of Examples and Comparative Examples described later was molded into a pellet by use of an injection molding machine [PS-40E: manufactured by Nissei Plastic Industrial Co., Ltd.], thereby preparing a molded article of 60 mm in length × 60 mm in width × 1.0 mm in thickness.

In the molding, the time for injection and pressure keeping was set to 2 seconds, the cooling time was set to 6 seconds, the mold temperature was set to 130°C, and the melt resin temperature was set to a temperature higher than the melting point Tm2 of polyamide (A) by 10°C.

Evaluation and rating of the moldability were conducted as follows. It was evaluated that a molded article was obtained without any problem to thereby lead to an enhancement in productivity.

◎: Molded article was obtained without any problem.
○: Molded article was released and obtained without any problem, but burr was caused.
Δ: Spray sometimes remained in mold.
×: Releasability was insufficient, and molded article was attached to mold and/or was decomposed.

[Production of polyamide (A)]

(Production Example 1)

In 1500 g of distilled water were dissolved 896 g (5.20 mol) of CHDA and 604 g (5.20 mol) of 2MC5DA, to prepare a water mixed liquid of such raw material monomers in equivalent molar concentrations (50% by mass).

The resulting water mixed liquid, and 15 g (0.15 mol) of 2MC5DA that was an additive in melt polymerization were loaded in an autoclave having an inner volume of 5.4 L (manufactured by Nitto Kouatsu).

Next, warming was conducted until the liquid temperature (internal temperature) in the autoclave reached 50°C.

Thereafter, the autoclave was purged with nitrogen.

Heating was continued until the pressure in the tank of the autoclave (hereinafter, simply referred to as "tank") reached a gauge pressure of about 2.5 kg/cm$^2$ (hereinafter, the pressure in the tank was designated as the gauge pressure, in all cases). The liquid temperature here was about 145°C.

While water was removed outside the system in order to keep the pressure in the tank at about 2.5 kg/cm$^2$, heating was continued for concentrating until the concentration of an aqueous solution in the tank reached about 85% by mass.

The removal of water was stopped, and heating was continued until the pressure in the tank reached about 30 kg/cm$^2$.

While water was removed outside the system in order to keep the pressure in the tank at about 30 kg/$cm^2$, heating was continued until the temperature reached a temperature lower than the final temperature (about 345°C) by 50°C (about 295°C). While heating was further continued, the pressure in the tank was decreased to the atmospheric pressure (gauge pressure: 0 kg/$cm^2$) over 60 minutes. The heater temperature was adjusted so that the final temperature of the resin temperature (liquid temperature) in the tank was about 345°C.
While the resin temperature in the tank was kept as it was, the tank was maintained under a reduced pressure of 100 torr in a vacuum apparatus for 10 minutes. Thereafter, the tank was pressurized by nitrogen, and a product was discharged through a lower spinneret (nozzle) so as to have a strand shape. Furthermore, the strand-shaped product was cooled by water and cut to provide a pellet-shaped polyamide (polyamide pellet).
Ten kg of the polyamide pellet obtained using melt polymerization was placed in a cone-shaped ribbon vacuum dryer (manufactured by Okawara Mfg. Co., Ltd., tradename: Ribocone RM-10V), and the vacuum dryer was sufficiently purged with nitrogen.
While nitrogen was allowed to flow in the vacuum dryer at 1 L/min, the polyamide pellet was heated at 260°C for 6 hours with stirring. Thereafter, the temperature in the vacuum dryer was decreased to about 50°C while nitrogen being allowed to flow, and the polyamide pellet was taken out from the vacuum dryer while the pellet shape thereof being kept, to provide a polyamide (hereinafter, also referred to as "PA-1").
The resulting polyamide was dried in nitrogen stream for adjustment of the water content to less than about 0.2% by mass, and then respective physical properties of the polyamide were measured based on the above measurement methods.
As the measurement results, the melting point Tm2 was 327°C, the glass transition temperature Tg was 150°C, the trans isomer ratio was 71%, and the sulfuric acid relative viscosity at 25°C was 3.1.

(Production Example 2)

In 1500 g of distilled water were dissolved 782 g (4.54 mol) of CHDA, 575 g (3.63 mol) of C9DA and 144 g (0.91 mol) of 2MC9DA, to prepare a water mixed liquid of such raw material monomers in equivalent molar concentrations (50% by mass).
The resulting water mixed liquid, and 11 g (0.07 mol) of C9DA that was an additive in melt polymerization were loaded in an autoclave having an inner volume of 5.4 L (manufactured by Nitto Kouatsu).
Next, warming was conducted until the liquid temperature (internal temperature) in the autoclave reached 50°C.
Thereafter, the autoclave was purged with nitrogen. Heating was continued until the pressure in the tank of the autoclave reached a gauge pressure of about 2.5 kg/$cm^2$. The liquid temperature here was about 145°C.
While water was removed outside the system in order to keep the pressure in the tank at about 2.5 kg/$cm^2$, heating was continued for concentrating until the concentration of an aqueous solution in the tank reached about 75% by mass. The removal of water was stopped, and heating was continued until the pressure in the tank reached about 30 kg/$cm^2$.
While water was removed outside the system in order to keep the pressure in the tank at about 30 kg/$cm^2$, heating was continued until the temperature reached a temperature lower than the final temperature (about 340°C) by 50°C (about 290°C). While heating was further continued, the pressure in the tank was decreased to the atmospheric pressure (gauge pressure: 0 kg/$cm^2$) over 90 minutes.
The heater temperature was adjusted so that the final temperature of the resin temperature (liquid temperature) in the tank was about 340°C. While the resin temperature in the tank was kept as it was, the tank was maintained under a reduced pressure of 400 torr in a vacuum apparatus for 30 minutes. Thereafter, the tank was pressurized by nitrogen, and a product was discharged through a lower spinneret (nozzle) so as to have a strand shape. Furthermore, the strand-shaped product was cooled by water and cut to provide a pellet-shaped polyamide (hereinafter, also referred to as "PA-2") .
The resulting polyamide was dried in nitrogen stream for adjustment of the water content to less than about 0.2% by mass, and then respective physical properties of the polyamide were measured based on the above measurement methods.
As the measurement results, the melting point Tm2 was 316°C, the glass transition temperature Tg was 119°C, the trans isomer ratio was 70%, and the sulfuric acid relative viscosity at 25°C was 2.4.

(Production Example 3)

A polyamide (hereinafter, also referred to as "PA-3") was obtained by the same polymerization method as that described in Production Example 1 except that 750 g (4.35 mol) of 1,4-cyclohexanedicarboxylic acid (CHDA) was used as the raw material dicarboxylic acid, 750 g (4.35 mol) of 1,10-diaminodecane (C10DA) was used as the raw material diamine, 15 g (0.09 mol) of C10DA was used as the additive in melt polymerization, and the final temperature of the resin temperature (liquid temperature) was changed to 355°C.

The resulting polyamide was dried in nitrogen stream for adjustment of the water content to less than about 0.2% by mass, and then respective physical properties of the polyamide were measured based on the above measurement methods.

As the measurement results, the melting point Tm2 was 334°C, the amount of heat of fusion, ΔH, was 35 J/g, the glass transition temperature Tg was 121°C, the trans isomer ratio was 70%, and the sulfuric acid relative viscosity at 25°C was 2.3.

(Production Example 4)

Polyamide 9T (hereinafter, also abbreviated as "PA-4") was produced according to the method described in Example 1 in Japanese Patent Laid-Open No. 7-228689.

Here, terephthalic acid was used as the raw material dicarboxylic acid, and 1,9-nonamethylenediamine and 2-methyloctamethylenediamine [1,9-nonamethylenediamine : 2-methyloctamethylenediamine = 80 : 20 (molar ratio)] were used as the raw material diamine.

Specifically, the above respective raw materials, distilled water and the like were placed in an autoclave having a volume of 20 L to provide a water mixed liquid. Next, the autoclave was purged with nitrogen.

Thereafter, the water mixed liquid in the autoclave was stirred at 100°C for 30 minutes.

Next, the internal temperature of the autoclave was heated to 210°C over 2 hours. Here, the pressure in the autoclave was increased to 22 $kg/cm^2$.

After the reaction was continued for 1 hour as it was, the internal temperature of the autoclave was increased to 230°C. For 2 hours thereafter, the internal temperature of the autoclave was constantly kept at 230°C, and the reaction was conducted while distilled water was gradually drained and the pressure in the autoclave was kept at 22 $kg/cm^2$.

Next, the pressure in the autoclave was decreased to 10 $kg/cm^2$ over 30 minutes, and the reaction was conducted for additional 1 hour to provide a prepolymer.

The resulting prepolymer was dried under reduced pressure at 100°C for 12 hours, and pulverized to a size of 2 mm or less. The prepolymer pulverized was subjected to solid phase polymerization at 230°C under 0.1 mmHg for 10 hours to provide polyamide (PA-4).

Respective physical properties of polyamide (PA-4) were measured based on the above measurement methods.

As the measurement results, the melting point Tm2 was 298°C, the glass transition temperature Tg was 122°C, and the sulfuric acid relative viscosity at 25°C was 2.6.

(Production Example 5)

Polyamide 10T (hereinafter, also referred to as "PA-5") was obtained by the same operation as in Production Example 1 except that terephthalic acid was used as the dicarboxylic acid forming the dicarboxylic acid unit (a) and 1,10-diaminodecane (C10DA) was used as the diamine forming the diamine unit (b). Respective physical properties of the polyamide were measured based on the above measurement methods.

As the measurement results, the melting point Tm2 was 315°C, the amount of heat of fusion, ΔH, was 43J/g, the glass transition temperature Tg was 116°C, and the sulfuric acid relative viscosity at 25°C was 2.0.

[Production of polyamide composition]

(Examples 1 to 19 and Comparative Examples 1 to 10)

Each of polyamides (PA-1) to (PA-5) obtained in Production Examples 1 to 5, and the respective raw materials were used in types and proportions shown in Table 1 and Table 2 below, to produce each polyamide composition as follows.

Herein, polyamide (PA-1) obtained in Production Example 1 above was dried in nitrogen stream for adjustment of the water content to about 0.2% by mass and then used as a raw material of the polyamide composition.

A biaxial extruder [ZSK-26MC: manufactured by Coperion GmbH (Germany)] was used as the production apparatus of the polyamide composition.

The biaxial extruder had an upstream feed port in the first barrel close to the extruder upstream, a first downstream feed port in the sixth barrel, and a second downstream feed port in the ninth barrel. In the biaxial extruder, the L/D (the cylinder length of the extruder/the cylinder diameter of the extruder) was 48, and the number of barrels was 12.

In the biaxial extruder, the temperature in the region from the upstream feed port to the die was set to a temperature higher than the melting point Tm2 of polyamide (A) produced in each of Production Examples by 20°C, the number of rotations of the screw was set to 250 rpm, and the amount to be discharged was set to 25 kg/h.

The polyamide (A), the metal hydroxide (C), the metal oxide (D) and the phosphorus-based compound (E)

were dry blended so that the types and proportions were as shown in Table 1 and Table 2, and then fed through the upstream feed port of the biaxial extruder.

Next, when each polyamide composition shown in Table 1 was produced, the titanium oxide (B) was fed in the type and proportion shown in Table 1, through the first downstream feed port of the biaxial extruder.

Furthermore, the inorganic filler (F) was fed in the type and proportion shown in Table 1 and Table 2 below, through the second downstream feed port of the biaxial extruder.

The raw materials fed as described above were molten and kneaded in the biaxial extruder to prepare a polyamide composition pellet.

The resulting polyamide composition pellet was dried in nitrogen stream to allow the water content in the polyamide composition to be 500 ppm or less.

The polyamide composition after adjustment of the water content was variously evaluated as described above.

The evaluation results are shown in Table 1 and Table 2 below.

[Table 1]

| | Type | Unit | Example 1 | Reference Example 2 | Example 3 | Reference Example 4 | Example 5 | Example 6 | Example 7 | Example 8 | Example 9 | Example 10 | Example 11 | Example 12 | Example 13 | Example 14 | Comparative Example 1 | Comparative Example 2 | Comparative Example 3 | Comparative Example 4 | Comparative Example 5 | Comparative Example 6 |
|---|---|---|---|---|---|---|---|---|---|---|---|---|---|---|---|---|---|---|---|---|---|---|
| (A) Polyamide | PA-1 | % by mass | 37.7 | 37.7 | 37.7 | 37.7 | 38.1 | 38.1 | 37.3 | 37.3 | 36.7 | 38.2 | | | | | 39.3 | 38.5 | 38.5 | 38.5 | 37.8 | |
| | PA-2 | % by mass | | | | | | | | | | | 37.7 | | | | | | | | | |
| | PA-3 | % by mass | | | | | | | | | | | | 37.7 | | | | | | | | |
| | PA-4 | % by mass | | | | | | | | | | | | | 37.7 | | | | | | | 37.8 |
| | PA-5 | % by mass | | | | | | | | | | | | | | 37.7 | | | | | | |
| (B) Titanium oxide | B-1 | % by mass | 20 | 20 | 20 | 20 | 20 | 20 | 20 | 20 | 20 | 20 | 20 | 20 | 20 | 20 | 20 | 20 | 20 | 20 | 20 | 20 |
| (C) Metal hydroxide | C-1 | % by mass | 0.8 | | | | | | | | | | | | | | | | | | | |
| | C-2 | % by mass | | 0.8 | | | | | | | | | | | | | | | | | | |
| (D) Metal oxide | D-1 | % by mass | | | 0.8 | | 1.0 | 0.2 | 1.2 | 0.8 | 0.8 | 0.8 | 0.8 | 0.8 | 0.8 | 0.8 | | | 0.8 | 0.8 | 1.5 | 1.5 |
| | D-2 | % by mass | | | | 0.8 | | | | | | | | | | | | | | | | |
| (E) Phosphorus-based compound | E-1 | % by mass | 0.8 | 0.8 | 0.8 | 0.8 | 0.2 | 1.0 | 0.8 | 1.2 | 1.8 | | 0.8 | 0.8 | 0.8 | 0.8 | | 0.8 | | | | |
| | E-2 | % by mass | | | | | | | | | | 0.3 | | | | | | | | 0.05 | | |
| Phenol-based antioxidant | | % by mass | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 | 0.2 |
| (F) Inorganic filler | F | % by mass | 40 | 40 | 40 | 40 | 40 | 40 | 40 | 40 | 40 | 40 | 40 | 40 | 40 | 40 | 40 | 40 | 40 | 40 | 40 | 40 |
| Nucleating agent | | % by mass | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 | 0.5 |
| Metal element concentrations derived from (C), (D) and (E) included in polyamide composition | | ppm | 6201 | 5215 | 7588 | 6706 | 7603 | 3779 | 10441 | 8529 | 9940 | 6357 | 7588 | 7588 | 7588 | 7588 | 0 | 1882 | 5706 | 5815 | 10699 | 10699 |
| Phosphorus element concentration derived from (E) included in polyamide composition | | ppm | 2917 | 2917 | 2917 | 2917 | 729 | 3646 | 2917 | 4375 | 6563 | 877 | 2917 | 2917 | 2917 | 2917 | 0 | 2917 | 0 | 146 | 0 | 0 |
| Melting point Tm2 | | °C | 327 | 327 | 327 | 327 | 327 | 327 | 327 | 327 | 327 | 327 | 316 | 334 | 298 | 315 | 327 | 327 | 327 | 327 | 327 | 298 |
| Tg | | °C | 150 | 150 | 150 | 150 | 150 | 150 | 150 | 150 | 150 | 150 | 119 | 121 | 122 | 116 | 150 | 150 | 150 | 150 | 150 | 122 |
| Crystallization peak temperature Tc | | °C | 253 | 253 | 253 | 253 | 253 | 253 | 253 | 253 | 253 | 253 | 276 | 281 | 262 | 271 | 253 | 253 | 253 | 253 | 253 | 262 |
| Tc-Tg | | °C | 103 | 103 | 103 | 103 | 103 | 103 | 103 | 103 | 103 | 103 | 157 | 160 | 140 | 155 | 103 | 103 | 103 | 103 | 103 | 140 |
| Initial reflectance | | % | 95.9 | 95.7 | 95.1 | 94.8 | 94.3 | 95.8 | 95.8 | 96.3 | 96.3 | 94.9 | 94.8 | 95.0 | 94.4 | 94.4 | 93.5 | 94.9 | 93.9 | 94.0 | 94.8 | 94.8 |
| Reflectance retention rate after reflow step | | % | 93 | 91 | 89 | 84 | 88 | 86 | 94 | 94 | 92 | 87 | 86 | 86 | 83 | 84 | 69 | 79 | 83 | 83 | 86 | 86 |
| Reflectance retention rate after heat treatment | | % | 84 | 81 | 83 | 79 | 79 | 75 | 80 | 85 | 79 | 81 | 71 | 71 | 74 | 73 | 63 | 73 | 77 | 77 | 80 | 80 |
| Reflectance retention rate after metal halide exposure test | | % | 100 | 100 | 100 | 100 | 99 | 100 | 100 | 100 | 100 | 100 | 100 | 100 | 95 | 96 | 89 | 100 | 93 | 93 | 94 | 88 |
| Extrusion processability | | Number of times | 0 | 0 | 0 | 0 | 0 | 0 | 0 | 0 | 2 | 4 | 0 | 0 | 0 | 0 | 0 | 6 | 0 | 0 | 0 | 0 |

[Table 2]

| | Type | Unit | Example 15 | Example 16 | Example 17 | Example 18 | Example 19 | Comparative Example 7 | Comparative Example 8 | Comparative Example 9 | Comparative Example 10 |
|---|---|---|---|---|---|---|---|---|---|---|---|
| (A) Polyamide | PA-1 | % by mass | 37.2 | 37.7 | 37.7 | | | 38.8 | 38.0 | 38.0 | |
| | PA-2 | % by mass | | | | 37.2 | | | | | |
| | PA-4 | % by mass | | | | | 37.2 | | | | 38.8 |
| (D) Metal oxide | D-1 | % by mass | 0.8 | 0.8 | 0.8 | 0.8 | 0.8 | | | 0.8 | |
| (E) Phosphorus-based compound | E-1 | % by mass | 0.8 | 0.8 | | 0.8 | 0.8 | | 0.8 | | |
| | E-2 | % by mass | | | 0.3 | | | | | | |
| Phenol-based antioxidant | | % by mass | 0.2 | 0.2 | 0.2 | 0.2 | 0.2 | 0.2 | 0.2 | 0.2 | 0.2 |
| (F) Inorganic filler | F | % by mass | 60 | 60 | 60 | 60 | 60 | 60 | 60 | 60 | 60 |
| Silicone compound | | % by mass | 0.5 | 0.5 | 0.5 | 0.5 | 0.5 | 0.5 | 0.5 | 0.5 | 0.5 |
| Nucleating agent | | % by mass | 0.5 | | 0.5 | 0.5 | 0.5 | 0.5 | 0.5 | 0.5 | 0.5 |
| Metal element concentrations derived from components (C), (D) and (E) included in polyamide composition | | ppm | 7588 | 7588 | 6357 | 7588 | 7588 | 0 | 1882 | 5706 | 0 |
| Phosphorus element concentration derived from component (E) included in polyamide composition | | ppm | 2917 | 2917 | 877 | 2917 | 2917 | 0 | 2917 | 0 | 0 |
| Melting point Tm2 | | °C | 327 | 327 | 327 | 316 | 298 | 327 | 327 | 327 | 298 |

(continued)

| Type | Unit | Example 15 | Example 16 | Example 17 | Example 18 | Example 19 | Comparative Example 7 | Comparative Example 8 | Comparative Example 9 | Comparative Example 10 |
|---|---|---|---|---|---|---|---|---|---|---|
| To | °C | 150 | 150 | 150 | 119 | 122 | 150 | 150 | 150 | 122 |
| Crystallization peak temperature Tc | °C | 253 | 243 | 253 | 276 | 262 | 249 | 253 | 253 | 262 |
| Tc-Tg | °C | 103 | 93 | 103 | 157 | 140 | 99 | 103 | 103 | 140 |
| Moldability | | ◎ | △ | ◎ | ◎ | ○ | × | △ | △ | △ |
| Initial reflectance | % | 86.1 | 86.1 | 85.5 | 85.4 | 84.2 | 82.2 | 84.7 | 83.3 | 79.9 |
| Reflectance retention rate after reflow step | % | 85 | 85 | 82 | 81 | 77 | 68 | 72 | 77 | 60 |
| Reflectance retention rate after heat treatment | % | 74 | 71 | 74 | 67 | 66 | 55 | 61 | 66 | 51 |
| Reflectance retention rate after metal halide exposure test | % | 99 | 99 | 99 | 99 | 92 | 85 | 99 | 89 | 79 |
| Extrusion processability | Number of times | 0 | 0 | 4 | 0 | 0 | 0 | 5 | 0 | 0 |

As shown in Table 1, it was found that the polyamide composition in each of Examples 1 to 14 was high in extrusion processability, initial reflectance, reflectance retention rate after the reflow step, reflectance retention rate after the heat treatment, and reflectance retention rate in the metal halide exposure test.

As shown in Table 2, it was found that the polyamide composition in each of Examples 15 to 19 contained the metal hydroxide (C) and/or the metal oxide (D), and the phosphorus-based compound (E), and thus could exhibit excellent moldability.

In particular, it was found from comparison of Examples 15 and 16 that a polyamide composition containing a proper amount of a nucleating agent such as talc, as the polyamide composition of the present invention, was much more excellent in plasticization stability and high in crystallization rate, and could be molded in a short molding cycle.

Furthermore, it was found that, when the crystal state of the surface of the molded article of the polyamide composition in each of Examples 1 to 15, 17 to 19 was confirmed by differential scanning calorimetry (DSC), sufficient crystallization was conducted in the mold.

Moreover, it has been indicated from the foregoing results that the polyamide composition of the present invention is excellent in each reflectance retention rate and can be used in a reflective plate for LED.

[Industrial Applicability]

The polyamide composition of the present invention is industrially applicable in various component materials for automobiles, electric and electronics, industrial materials, and daily and household items.

## Claims

1. A polyamide composition comprising:

    a polyamide (A),
    0.1 to 20% by mass of metal hydroxide (C), wherein the metal hydroxide is calcium hydroxide and/or metal oxide (D) wherein the metal oxide is calcium oxide,
    0.1 to 20% by mass of a phosphorus-based compound (E),

    and
    5% by mass or more of an inorganic filler (F) selected from the group consisting of glass fiber, carbon fiber, calcium silicate fiber, potassium titanate fiber, aluminum borate fiber, glass flake, talc, kaolin, mica, hydrotalcite, calcium carbonate, zinc carbonate, zinc oxide, wollastonite, silica, zeolite, alumina, boehmite, aluminum hydroxide, silicon oxide, calcium silicate, sodium aluminosilicate, magnesium silicate, carbon nanotube, graphite, brass, copper, silver, aluminum, nickel, iron, calcium fluoride, montmorillonite, and swellable fluorine mica .

2. The polyamide composition according to claim 1, wherein the polyamide (A) has a melting point Tm2 measured according to a method defined in the description of 270 to 350°C.

3. The polyamide composition according to claim 1 or 2, wherein the polyamide (A) is a polyamide comprising a dicarboxylic acid comprising 50% by mol or more of an alicyclic dicarboxylic acid as a monomer for polymerization.

4. The polyamide composition according to claim 3, wherein the alicyclic dicarboxylic acid comprises 1,4-cyclohexanedicarboxylic acid.

5. The polyamide composition according to any one of claims 1 to 4, further comprising 5% by mass or more of a titanium oxide (B).

6. The polyamide composition according to any one of claims 1 to 5, wherein the phosphorus-based compound (E) is a metal salt, and a metal element of the metal salt is the same as a metal element of the metal hydroxide (C) and/or the metal oxide (D).

7. The polyamide composition according to any one of claims 1 to 5, wherein the phosphorus-based compound (E) is an alkaline earth metal salt.

8. The polyamide composition according to any one of claims 1 to 7, further comprising 0.001 to 15% by mass of a nucleating agent selected from the group consisting of boron nitride, barium sulfate, silicon nitride, carbon black,

and molybdenum disulfide.

**9.** The polyamide composition according to any one of claims 1 to 8, wherein a phosphorus element concentration derived from the phosphorus-based compound (E) comprised in the polyamide composition is 1,400 to 20,000 ppm, and a difference (Tc - Tg) between a crystallization peak temperature Tc obtained in cooling at 100°C/min in differential scanning calorimetry according to JIS-K7121, and a glass transition temperature Tg obtained in heating at 20°C/min in differential scanning calorimetry according to JIS-K7121 is 100°C or higher.

**10.** A molded article comprising the polyamide composition according to any one of claims 1 to 9.

**11.** The molded article according to claim 10, wherein a reflectance retention rate measured according to a method defined in the description after exposure for 1000 hours by a metal halide lamp system light resistance tester at 100°C and at a position where an illuminance is 10 mW/cm$^2$ is 95% or more.

**12.** A reflective plate for LED, comprising the polyamide composition according to any one of claims 1 to 9.

**Patentansprüche**

**1.** Polyamidzusammensetzung, umfassend:

ein Polyamid (A),
0,1 bis 20 Massen-% Metallhydroxid (C), wobei es sich bei dem Metallhydroxid um Calciumhydroxid handelt, und/oder Metalloxid (D), wobei es sich bei dem Metalloxid um Calciumoxid handelt,
0,1 bis 20 Massen-% einer auf Phosphor basierenden Verbindung (E) und
5 Massen-% oder mehr eines anorganischen Füllstoffs (F) aus der Gruppe bestehend aus Glasfaser, Kohlefaser, Calciumsilikatfaser, Kaliumtitanatfaser, Aluminiumboratfaser, Glasplättchen, Talk, Kaolin, Glimmer, Hydrotalcit, Calciumcarbonat, Zinkcarbonat, Zinkoxid, Wollastonit, Kieselsäure, Zeolith, Aluminiumoxid, Böhmit, Aluminiumhydroxid, Siliciumoxid, Calciumsilikat, Natriumaluminosilikat, Magnesiumsilicat, Kohlenstoffnanoröhre, Graphit, Messing, Kupfer, Silber, Aluminium, Nickel, Eisen, Calciumfluorid, Montmorillonit und quellbarem Fluorglimmer.

**2.** Polyamidzusammensetzung nach Anspruch 1, wobei das Polyamid (A) einen gemäß einer in der Beschreibung definierten Methode gemessenen Schmelzpunkt Tm2 von 270 bis 350 °C aufweist.

**3.** Polyamidzusammensetzung nach Anspruch 1 oder 2, wobei es sich bei dem Polyamid (A) um ein Polyamid handelt, das eine Dicarbonsäure umfasst, die 50 Mol-% oder mehr einer alicyclischen Dicarbonsäure als Monomer für die Polymerisation umfasst.

**4.** Polyamidzusammensetzung nach Anspruch 3, wobei die alicyclische Dicarbonsäure 1,4-Cyclohexandicarbonsäure umfasst.

**5.** Polyamidzusammensetzung nach einem der Ansprüche 1 bis 4, ferner umfassend fünf Massen-% oder mehr eines Titanoxids (B).

**6.** Polyamidzusammensetzung nach einem der Ansprüche 1 bis 5, wobei es sich bei der auf Phosphor basierenden Verbindung (E) um ein Metallsalz handelt und ein Metallelement des Metallsalzes mit einem Metallelement des Metallhydroxids (C) und/oder des Metalloxids (D) identisch ist.

**7.** Polyamidzusammensetzung nach einem der Ansprüche 1 bis 5, wobei es sich bei der auf Phosphor basierenden Verbindung (E) um ein Erdalkalimetallsalz handelt.

**8.** Polyamidzusammensetzung nach einem der Ansprüche 1 bis 7, ferner umfassend 0,001 bis 15 Massen-% eines Nukleierungsmittels aus der Gruppe bestehend aus Bornitrid, Bariumsulfat, Siliciumnitrid, Ruß und Molybdändisulfid.

**9.** Polyamidzusammensetzung nach einem der Ansprüche 1 bis 8, wobei die aus der auf Phosphor basierenden Verbindung (E) stammende Phosphorelementkonzentration in der Polyamidzusammensetzung 1400 bis 20.000 ppm beträgt und die Differenz (Tc - Tg) zwischen der beim Abkühlen mit 100 °C/min bei der Differentialkalorimetrie

gemäß JIS-K7121 erhaltenen Kristallisationspeaktemperatur Tc und der beim Erhitzen mit 20 °C/min bei der Differentialkalorimetrie gemäß JIS-K7121 erhaltenen Glasübergangstemperatur Tg 100 °C oder mehr beträgt.

**10.** Formkörper, umfassend die Polyamidzusammensetzung nach einem der Ansprüche 1 bis 9.

**11.** Formkörper nach Anspruch 10, wobei die gemäß einer in der Beschreibung definierten Methode gemessene Reflexionsgrad-Retentionsrate nach 1000 Stunden Exposition mit einem Metallhalogenidlampensystem-Lichtbeständigkeitsprüfgerät bei 100 °C und in einer Position, in der die Beleuchtungsstärke 10 mW/$cm^2$ beträgt, 95 % oder mehr beträgt.

**12.** Reflektive Platte für LED, umfassend die Polyamidzusammensetzung nach einem der Ansprüche 1 bis 9.

**Revendications**

**1.** Composition de polyamide comprenant :

un polyamide (A),
0,1 à 20 % en masse d'un hydroxyde métallique (C), l'hydroxyde métallique étant l'hydroxyde de calcium et/ou un oxyde métallique (D), l'oxyde métallique étant l'oxyde de calcium,
0,1 à 20 % en masse d'un composé (E) à base de phosphore,
et
5 % en masse ou plus d'une charge inorganique (F) choisie dans le groupe constitué par les fibres de verre, les fibres de carbone, les fibres de silicate de calcium, les fibres de titanate de potassium, les fibres de borate d'aluminium, les paillettes de verre, le talc, le kaolin, le mica, l'hydrotalcite, le carbonate de calcium, le carbonate de zinc, l'oxyde de zinc, la wollastonite, la silice, une zéolithe, l'alumine, la boehmite, l'hydroxyde d'aluminium, l'oxyde de silicium, le silicate de calcium, l'aluminosilicate de sodium, le silicate de magnésium, un nanotube de carbone, le graphite, le laiton, le cuivre, l'argent, l'aluminium, le nickel, le fer, le fluorure de calcium, la montmorillonite, et le mica fluoré expansible.

**2.** Composition de polyamide selon la revendication 1, le polyamide (A) possédant un point de fusion Tm2, mesuré selon un procédé défini dans la description, de 270 à 350 °C.

**3.** Composition de polyamide selon la revendication 1 ou 2, le polyamide (A) étant un polyamide comprenant un acide dicarboxylique comprenant 50 % en moles ou plus d'un acide dicarboxylique alicyclique en tant qu'un monomère pour une polymérisation.

**4.** Composition de polyamide selon la revendication 3, l'acide dicarboxylique alicyclique comprenant l'acide 1,4-cyclohexanedicarboxylique.

**5.** Composition de polyamide selon l'une quelconque des revendications 1 à 4, comprenant en outre 5 % en masse ou plus d'un oxyde de titane (B).

**6.** Composition de polyamide selon l'une quelconque des revendications 1 à 5, le composé (E) à base de phosphore étant un sel métallique, et un élément métallique du sel métallique étant identique à un élément métallique de l'hydroxyde métallique (C) et/ou de l'oxyde métallique (D).

**7.** Composition de polyamide selon l'une quelconque des revendications 1 à 5, le composé (E) à base de phosphore étant un sel de métal alcalino-terreux.

**8.** Composition de polyamide selon l'une quelconque des revendications 1 à 7, comprenant en outre 0,001 à 15 % en masse d'un agent de nucléation choisi dans le groupe constitué par le nitrure de bore, le sulfate de baryum, le nitrure de silicium, le noir de carbone, et le disulfure de molybdène.

**9.** Composition de polyamide selon l'une quelconque des revendications 1 à 8, une concentration en élément phosphore issu du composé (E) à base de phosphore compris dans la composition de polyamide étant de 1 400 à 20 000 ppm, et une différence (Tc - Tv) entre une température de pic de cristallisation Tc obtenue en refroidissant à 100 °C/min en calorimétrie différentielle à balayage selon la norme JIS-K7121, et une température de transition vitreuse Tv

obtenue en chauffant à 20 °C/min en calorimétrie différentielle à balayage selon la norme JIS-K7121, étant de 100 °C ou plus.

**10.** Article moulé comprenant une composition de polyamide selon l'une quelconque des revendications 1 à 9.

**11.** Article moulé selon la revendication 10, un taux de rétention de réflectance mesuré selon un procédé défini dans la description après une exposition pendant 1 000 heures à un testeur de résistance à la lumière à système de lampe à halogénure métallique à 100 °C et à une position où un éclairement est de 10 $mW/cm^2$, étant de 95 % ou plus.

**12.** Plaque réfléchissante pour LED, comprenant la composition de polyamide selon l'une quelconque des revendications 1 à 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 6503590 A
- WO 11512476 A
- JP 2006257314 A
- JP 2011219697 A
- JP 5017413 A
- JP 7228689 A